# EUROPEAN PATENT SPECIFICATION

(11) **EP 4 485 438 B1**
(45) Date of publication and mention of the grant of the patent: **02.09.2026**
(21) Application number: 22966233.3
(22) Date of filing: 25.11.2022
(51) Int. Cl.: G09G 3/20, G09G 3/3266, G11C 19/28

(54) **DRIVING CIRCUIT, DRIVING METHOD, DISPLAY SUBSTRATE, AND DISPLAY DEVICE**
TREIBERSCHALTUNG, ANSTEUERUNGSVERFAHREN, ANZEIGESUBSTRAT UND ANZEIGEVORRICHTUNG
CIRCUIT D'ATTAQUE, PROCÉDÉ D'ATTAQUE, SUBSTRAT D'AFFICHAGE ET DISPOSITIF D'AFFICHAGE

(43) Date of publication of application: 01.01.2025
(73) Proprietor: Boe Technology Group Co., Ltd., Beijing 100015 (CN)
(72) Inventor: ZHAO, Donghui, Beijing 100176 (CN); XU, Pan, Beijing 100176 (CN); HAN, Ying, Beijing 100176 (CN); ZHANG, Xing, Beijing 100176 (CN); LUO, Chengyuan, Beijing 100176 (CN); LV, Guangshuang, Beijing 100176 (CN); YAO, Xing, Beijing 100176 (CN); ZHOU, Dandan, Beijing 100176 (CN); LIU, Miao, Beijing 100176 (CN)
(74) Representative: Isarpatent
(86) International application number: PCT/CN2022/134332
(87) International publication number: WO 2024/108544

(56) References cited:
- WO-A1-2021/227766
- WO-A1-2022/188019
- CN-A- 104 992 661
- CN-A- 111 445 832
- CN-A- 113 903 309
- CN-A- 114 945 969
- CN-U- 214 541 584
- KR-A- 20180 095 428
- US-A1- 2018 121 023
- US-A1- 2022 246 101
- US-A1- 2023 084 070
- US-A1- 2023 169 917

## Description

### TECHNICAL FIELD

The present disclosure relates to the field of display technology, in particular to a display device, a driving method and a display substrate.

### BACKGROUND

In the related art, in a driving circuitry, a potential at a first node is directly reset by a resetting transistor under the effect of a cut-off voltage signal (a cut-off voltage is, e.g., a low voltage). Negative drift easily occurs for a threshold voltage of a transistor (e.g., an oxide transistor), so when the resetting transistor needs to be cut off, it is cut off incompletely. At this time, a current leakage occurs due to a passage between a low voltage line and the first node, and the potential at the first node is pulled down, so an output of the driving circuitry is abnormal.

US 2018/0121023 A1 provides a gate driver and a display device having an in-cell touch sensor using the gate driver. The gate driver includes a shift register configured to sequentially supply gate pulses to gate lines of a display panel. The shift register includes an (N-1)th stage, where N is a positive integer equal to or greater than 2, configured to output an (N-1)th gate pulse, an Nth stage configured to output an Nth gate pulse, and a hold circuit configured to hold an output voltage of the (N-1)th stage during a predetermined time and supply the output voltage to the Nth stage.

US 2023/0084070 A1 provides a shift register unit, a signal generation unit circuit, a driving method and a display device. The shift register unit includes a first node control circuit, a second node control circuit and an output circuit, the first node control circuit is used to control a potential of a first node; the second node control circuit controls a potential of a second node; the output circuit is used to control and maintain the potential of the first node and the potential of the second node, and control to connect the output terminal and the second clock signal terminal under the control of the potential of the first node, and control to connect the input terminal and the second voltage terminal under the control of the potential of the second node.

US2023/169917A1 provides a shift register including a first transistor, a second transistor, a third transistor, a fourth transistor, a fifth transistor, a first capacitor and an impedance transistor; the second transistor has a first electrode coupled to a second node; the third transistor has a first electrode coupled to a first power terminal and a second electrode coupled to the second node; the fifth transistor has a control electrode coupled to a third node; the impedance transistor has a control electrode coupled to the first power terminal, a first electrode coupled to the second node, and a second electrode coupled to the third node.

### SUMMARY

The present invention is set out in the appended set of claims.

- [0036]

### BRIEF DESCRIPTION OF THE DRAWINGS

Fig. 1 is a schematic view showing a driving circuitry according to one embodiment of the present disclosure;
Fig. 2 is another schematic view showing the driving circuitry according to one embodiment of the present disclosure;
Fig. 3 is yet another schematic view showing the driving circuitry according to one embodiment of the present disclosure;
Fig. 4 is still yet another schematic view showing the driving circuitry according to one embodiment of the present disclosure;
Fig. 5 is still yet another schematic view showing the driving circuitry according to one embodiment of the present disclosure;
Fig. 6 is still yet another schematic view showing the driving circuitry according to one embodiment of the present disclosure;
Fig. 7 is a circuit diagram of the driving circuitry according to one embodiment of the present disclosure;
Fig. 8 is a sequence diagram of the driving circuitry in Fig. 7;
Fig. 9 is a simulated sequence diagram of the driving circuitry in Fig. 7 when a threshold voltage of an oxide transistor is 4 V;
Fig. 10 is a simulated sequence diagram of the driving circuitry in Fig. 7 when the threshold voltage of the oxide transistor is -2.5 V;
Fig. 11 is another circuit diagram of the driving circuitry according to one embodiment of the present disclosure;
Fig. 12 is yet another circuit diagram of the driving circuitry according to one embodiment of the present disclosure;
Fig. 13 is still yet another circuit diagram of the driving circuitry according to one embodiment of the present disclosure, which is not part of the invention;
Fig. 14 is still yet another circuit diagram of the driving circuitry according to one embodiment of the present disclosure;
Fig. 15 is still yet another circuit diagram of the driving circuitry according to one embodiment of the present disclosure;
Fig. 16 is a sequence diagram of the driving circuitry in Fig. 15;
Fig. 17 is a simulated sequence diagram of the driving circuitry in Fig. 15;
Fig. 18 is a schematic view showing the layout of the driving circuitry in Fig. 13;
Fig. 19A is a partially enlarged view of the driving circuitry in Fig. 18;
Fig. 19B is another partially enlarged view of the driving circuitry in Fig. 18;
Fig. 20 is a schematic view showing the layout of a semiconductor layer in Fig. 18;
Fig. 21 is a schematic view showing the layout of a gate metal layer in Fig. 18; and
Fig. 22 is a schematic view showing the layout of a source/drain metal layer in Fig. 18.

### DETAILED DESCRIPTION

In order to make the objects, the technical solutions and the advantages of the present disclosure more apparent, the present disclosure will be described hereinafter in a clear and complete manner in conjunction with the drawings and embodiments.

All transistors adopted in the embodiments of the present disclosure may be TFTs, field effect transistors (FETs) or any other elements having an identical characteristic. In order to differentiate two electrodes other than a gate electrode from each other, one of the two electrodes is called as first electrode and the other is called as second electrode.

In actual use, when the transistor is a TFT or FET, the first electrode may be a drain electrode and the second electrode may be a source electrode, or the first electrode may be a source electrode and the second electrode may be a drain electrode.

The present disclosure provides in some embodiments a driving circuitry, which includes a driving output circuitry, a first resetting circuitry and a first isolation circuitry. The driving output circuitry is electrically coupled to a first node and a driving signal output end, electrically coupled to a first voltage line or a first clock signal line, and configured to control the driving signal output end to be electrically coupled to the first voltage line or the first clock signal line under the control of a potential at the first node. The first resetting circuitry is electrically coupled to a first resetting line, the first clock signal line and a first control node, and configured to control the first clock signal line to write a first clock signal into the first control node under the control of a first resetting signal from the first resetting line. The first isolation circuitry is electrically coupled to a second clock signal line, the first control node and the first node, and configured to control the first control node to be electrically coupled to the first node under the control of a second clock signal from the second clock signal line.

According to the embodiments of the present disclosure, the driving circuitry includes the first resetting circuitry and the first isolation circuitry, the first setting circuitry is configured to write the first clock signal into the first control node under the control of the resetting signal, and the first isolation circuitry is configured to control the first control node to be electrically coupled to the first node under the control of the second clock signal. The potential at the first control node is reset through the first clock signal, and then the first control node is controlled by the first isolation circuitry to be electrically coupled to the first node under the control of the second clock signal, so as to reset the potential at the first node. The first clock signal is a periodic signal, so it is able to shorten a low-voltage time period and reduce a leakage current.

In at least one embodiment of the present disclosure, the first resetting line is but not limited to, a resetting line RST.

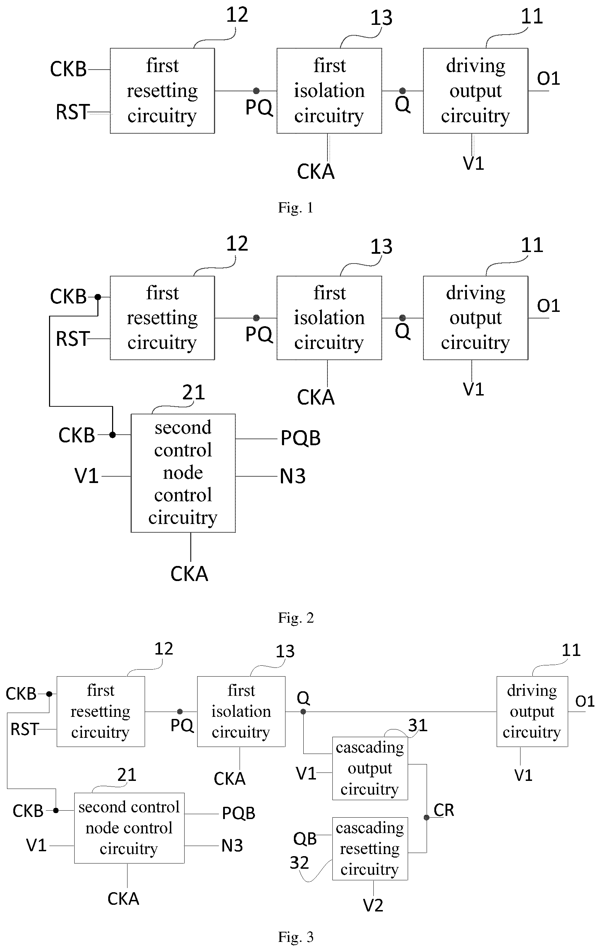

As shown in Fig. 1, the driving circuitry includes a driving output circuitry 11, a first resetting circuitry 12 and a first isolation circuitry 13. The driving output circuitry 11 is electrically coupled to a first node Q, a driving signal output end O1 and a first voltage line V1, and configured to control the driving signal output end O1 to be electrically coupled to the first voltage line V1 under the control of the potential at the first node Q. The first resetting circuitry 12 is electrically coupled to a resetting line RST, a first clock signal line CKB and a first control node PQ, and configured to control the first clock signal line CKB to write the first clock signal into the first control node PQ under the control of the resetting signal from the resetting line RST. The first isolation circuitry 13 is electrically coupled to a second clock signal line CKA, a first control node PQ and a first node Q, and configured to control the first control node PQ to be electrically coupled to the first node Q under the control of a second clock signal from the second clock signal line CKA.

In at least one embodiment of the present disclosure, the driving circuitry is an oxide internal compensation Pulse Width Modulation (PWM) circuitry.

In at least one embodiment of the present disclosure, the driving circuitry includes, but not limited to, an oxide transistor.

According to the embodiments of the present disclosure, the driving circuitry includes the first resetting circuitry 12 and the first isolation circuitry 13, the first setting circuitry 12 is configured to write the first clock signal into the first control node PQ under the control of the resetting signal, and the first isolation circuitry 13 is configured to control the first control node PQ to be electrically coupled to the first node Q under the control of the second clock signal. The potential at the first control node PQ is reset through the first clock signal, and then the first control node PQ is controlled by the first isolation circuitry 13 to be electrically coupled to the first node Q under the control of the second clock signal, so as to reset the potential at the first node Q. The first clock signal is a periodic signal, so it is able to shorten a low-voltage time period and reduce a leakage current.

In the related art, a potential at a first node is directly reset by a resetting transistor under the effect of a low voltage signal. Negative drift easily occurs for a threshold voltage of an oxide transistor, so when the resetting transistor needs to be cut off, it is cut off incompletely. At this time, a current leakage occurs due to a passage between a low voltage line and the first node, and the potential at the first node is pulled down. However, in the embodiments of the present disclosure, the potential at the first control node is reset through the first clock signal, and the first control node is controlled by the first isolation circuitry to be electrically coupled to the first node under the control of the second clock signal, so as to reset the potential at the first node.

In a possible embodiment of the present disclosure, the first resetting circuitry includes a first transistor, a gate electrode of the first transistor is electrically coupled to the first resetting line, a first electrode of the first transistor is electrically coupled to the first clock signal line, and a second electrode of the first transistor is electrically coupled to the first control node.

In at least one embodiment of the present disclosure, the first transistor is an oxide thin-film transistor, a first high voltage time period does not overlap with a second high voltage time period, the first high voltage time period is a time period within which a potential of the first clock signal is a high voltage, and the second high voltage time period is a time period within which a potential of the second clock signal is a high voltage.

The driving circuitry in the embodiments of the present disclosure further includes a second control node control circuitry electrically coupled to the first clock signal line, the first voltage line, a second control node, a third node and the second clock signal line, and configured to control the second control node to be electrically coupled to the first voltage line under the control of the first clock signal, control the third node to be electrically coupled to the second clock signal line under the control of a potential at the second control node, and control the potential at the second control node in accordance with a potential at the third node.

During the implementation, the driving circuitry further includes the second control node control circuitry, and the potential at the second control node is controlled by the second control node control circuitry in accordance with the second clock signal under the control of the first clock signal.

As shown in Fig. 2, on the basis of the driving circuitry in Fig. 1, the driving circuitry further includes a second control node control circuitry 21 electrically coupled to the first clock signal line CKB, the first voltage line V1, a second control node PQB, a third node N3 and the second clock signal line CKA, and configured to control the second control node PQB to be electrically coupled to the first voltage line V1 under the control of the first clock signal, and control the third node N3 to be electrically coupled to the second clock signal line CKA under the control of the potential at the second control node PQB.

In at least one embodiment of the present disclosure, the second control node control circuitry 21 controls the potential at the second control node PQB in accordance with the potential of the third node N3. At this time, the second control node control circuitry 21 includes a capacitor, a first end of which is electrically coupled to the third node N3 and a second end of which is electrically coupled to the second clock signal line CKA, so as to control the potential at the second control node PQB in accordance with the potential at the third node N3.

In at least one embodiment of the present disclosure, the first voltage line is, but not limited to, a first high voltage line.

The driving circuitry in the embodiments of the present disclosure further includes a cascading output circuitry and a cascading resetting circuitry (T12 and T13). The cascading output circuitry is electrically coupled to the first node, a carry output end and the first voltage line, and configured to control the carry output end to be electrically coupled to the first voltage line under the control of the potential at the first node. The cascading resetting circuitry is electrically coupled to a second node, the carry output end and a second voltage line, and configured to control the carry output end to be electrically coupled to the second voltage line under the control of a potential at the second node.

During the implementation, the driving circuitry further includes the cascading output circuitry and the cascading resetting circuitry, and the carry output end is notified through the cascading output circuitry and the cascading resetting circuitry to output a carry signal for cascading, so as to enhance the driving capability of the driving circuitry.

As shown in Fig. 3, on the basis of the driving circuitry in Fig. 2, the driving circuitry further includes a cascading output circuitry 31 and a cascading resetting circuitry 32. The cascading output circuitry 31 is electrically coupled to the first node Q, the carry output end CR and the first voltage line V1, and configured to control the carry output end CR to be electrically coupled to the first voltage line V1 under the control of the potential at the first node Q. The cascading resetting circuitry 32 is electrically coupled to a second node QB, the carry output end CR and a second voltage line V2, and configured to control the carry output end CR to be electrically coupled to the second voltage line V2 under the control of the potential at the second node QB.

In at least one embodiment of the present disclosure, the first voltage line V1 is, but not limited to, a first high voltage line and the second voltage line V2 is, but not limited to, a second low voltage line.

In a possible embodiment of the present disclosure, the cascading resetting circuitry includes a second transistor and a third transistor. A gate electrode of the second transistor is electrically coupled to the second node, a first electrode of the second transistor is electrically coupled to the carry output end, and a second electrode of the second transistor is electrically coupled to a fourth node. A gate electrode of the third transistor is electrically coupled to the second node, a first electrode of the third transistor is electrically coupled to the fourth node, and a second electrode of the third transistor is electrically coupled to the second voltage line.

The driving circuitry in the embodiments of the present disclosure further includes a first control circuitry electrically coupled to the first node, a third voltage line and the fourth node, and configured to control the third voltage line to be electrically coupled to the fourth node under the control of the potential at the first node.

In at least one embodiment of the present disclosure, the third voltage line is, but not limited to, a second high voltage line.

During the implementation, the driving circuitry further includes the first control circuitry, and the fourth node is controlled by the first control circuitry to be electrically coupled to the third voltage line under the control of the potential at the first node, so as to prevent the potential of the carry signal at the carry output end from decreasing due to the current leakage.

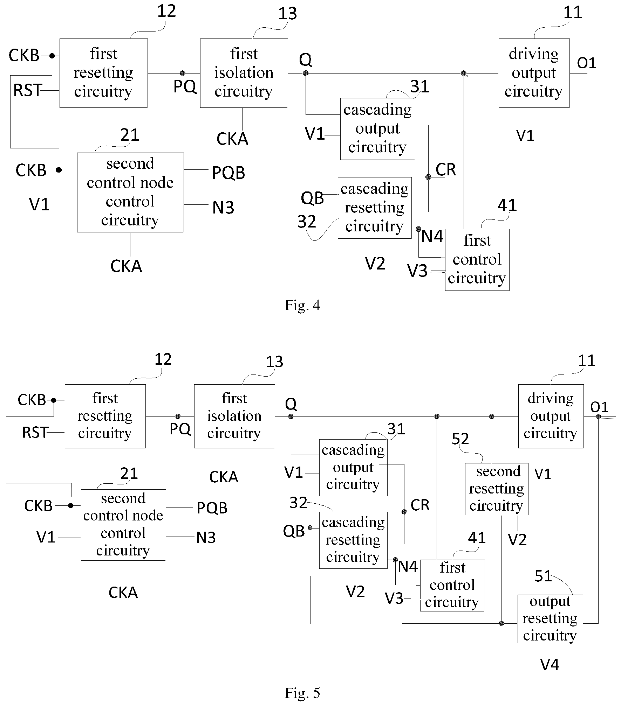

As shown in Fig. 4, on the basis of the driving circuitry in Fig. 3, the driving circuitry further includes a first control circuitry 41 electrically coupled to the first node Q, a third voltage line V3 and the fourth node N4, and configured to control the third voltage line V3 to be electrically coupled to the fourth node N4 under the control of the potential at the first node Q. The cascading resetting circuitry 32 is electrically coupled to the fourth node N4.

In a possible embodiment of the present disclosure, the first control circuitry includes a fourth transistor, a gate electrode of the fourth transistor is electrically coupled to the first node, a first electrode of the fourth transistor is electrically coupled to the third voltage line, and a second electrode of the fourth transistor is electrically coupled to the fourth node.

As shown in Fig. 5, on the basis of the driving circuitry in Fig. 4, the driving circuitry further includes a output resetting circuitry 51 and a second resetting circuitry 52. The output resetting circuitry 51 is electrically coupled to the second node QB, the driving signal output end O1 and the fourth voltage line V4, and configured to control the driving signal output end O1 to be electrically coupled to the fourth voltage line V4 under the control of the potential at the second node QB. The second resetting circuitry 52 is electrically coupled to the first node Q, the second voltage line V2 and the second node QB, and configured to control the second voltage line V2 to be electrically coupled to the second node QB under the control of the potential at the first node Q.

In at least one embodiment of the present disclosure, the fourth voltage line is, but not limited to, a first low voltage line and the second voltage line is, but not limited to, a second low voltage line.

During the operation of the driving circuitry in Fig. 5, the second resetting circuitry 52 controls the second node QB to be electrically coupled to the second voltage line V2 under the control of the potential at the first node Q, and the output resetting circuitry 51 controls the driving signal output end O1 to be electrically coupled to the fourth voltage line V4 under the control of the potential at the second node QB.

In a possible embodiment of the present disclosure, a transistor in the output resetting circuitry is an oxide transistor, and a voltage value of a second voltage signal from the second voltage line is less than a voltage value of a first voltage signal from the first voltage line, so as to prevent the occurrence of a current leakage when negative drift occurs for a threshold voltage of the transistor in the output resetting circuitry.

In a possible embodiment of the present disclosure, the output resetting circuitry includes a fifth transistor and a first capacitor, and the second resetting circuitry includes a sixth transistor. A gate electrode of the fifth transistor is electrically coupled to the second node, a first electrode of the fifth transistor is electrically coupled to the driving signal output end, and a second electrode of the fifth transistor is electrically coupled to the fourth voltage line. A first end of the first capacitor is electrically coupled to the second node, and a second end of the first capacitor is electrically coupled to the fourth voltage line. A gate electrode of the sixth transistor is electrically coupled to the first node, a first electrode of the sixth transistor is electrically coupled to the second voltage line, and a second electrode of the sixth transistor is electrically coupled to the second node.

In a possible embodiment of the present disclosure, the driving circuitry further includes a second control circuitry electrically coupled to the first control node, the second clock signal line, the second voltage line and the second control node, and configured to control the first control node to be electrically coupled to the second voltage line under the control of the potential at the second control node and the second clock signal from the second clock signal line.

During the implementation, the driving circuitry includes the second control circuitry, and the first control node is controlled by the second control circuitry to be electrically coupled to the second voltage line under the control of the potential at the second control node and the second clock signal from the second clock signal line.

The driving circuitry in the embodiments of the present disclosure further includes a third control circuitry electrically coupled to the second clock signal line, an input line and the first control node, and configured to control the input line to be electrically coupled to the first control node under the control of the second clock signal.

During the implementation, the driving circuitry includes the third control circuitry, the input line is controlled by the third control circuitry to be electrically coupled to the first control node under the control of the second clock signal.

The driving circuitry in the embodiments of the present disclosure further includes a fourth control circuitry electrically coupled to the first node, the first control node and the third voltage line, and configured to control the first control node to be electrically coupled to the third voltage line under the control of the potential at the first node.

During the implementation, the driving circuitry includes the fourth control circuitry, and the first control node is controlled by the fourth control circuitry to be electrically coupled to the third voltage line under the control of the potential at the first node.

In at least one embodiment of the present disclosure, the second control node control circuitry is further electrically coupled to the input line and configured to write the first clock signal into the second control node under the control of an input signal from the input line.

During the implementation, the second control node control circuitry writes the first clock signal into the second control node under the control of the input signal.

In a possible embodiment of the present disclosure, the second control node control circuitry includes a seventh transistor and an eighth transistor. A gate electrode of the seventh transistor is electrically coupled to the input line, a first electrode of the seventh transistor is electrically coupled to the first clock signal line, and a second electrode of the seventh transistor is electrically coupled to a first electrode of the eighth transistor. A gate electrode of the eighth transistor is electrically coupled to the input line, and a second electrode of the eighth transistor is electrically coupled to the second control node.

The driving circuitry in the embodiments of the present disclosure further includes a third resetting circuitry electrically coupled to a the second resetting line, the third voltage line, and the second node, and configured to control the third voltage line to be electrically coupled to the second node under the control of a second resetting signal from the second resetting line.

In at least one embodiment of the present disclosure, the first resetting line and the second resetting line may be the same or different.

In at least one embodiment of the present disclosure, the second resetting line is, but not limited to, a resetting line RST.

In a possible embodiment of the present disclosure, the third voltage line is, but not limited to, a second high voltage line.

During the implementation, the driving circuitry further includes the third resetting circuitry, and the second node is controlled by the third resetting circuitry to be electrically coupled to the third voltage line under the control of the resetting signal, so as to reset the potential at the second node.

In a possible embodiment of the present disclosure, the third resetting circuitry includes a ninth transistor and a tenth transistor. A gate electrode of the ninth transistor is electrically coupled to the second resetting line, a first electrode of the ninth transistor is electrically coupled to the third voltage line, and a second electrode of the ninth transistor is electrically coupled to a first electrode of the tenth transistor. A gate electrode of the tenth transistor is electrically coupled to the second resetting line, and a second electrode of the tenth transistor is electrically coupled to the second node.

The driving circuitry in the embodiments of the present disclosure further includes a second isolation circuitry electrically coupled to the second clock signal line, the third node and the second node, and configured to control the third node to be electrically coupled to the second node under the control of the second clock signal from the second clock signal line.

During the implementation, the driving circuitry further includes the second isolation circuitry, and the third node is controlled by the second isolation circuitry to be electrically coupled to the second node under the control of the second clock signal.

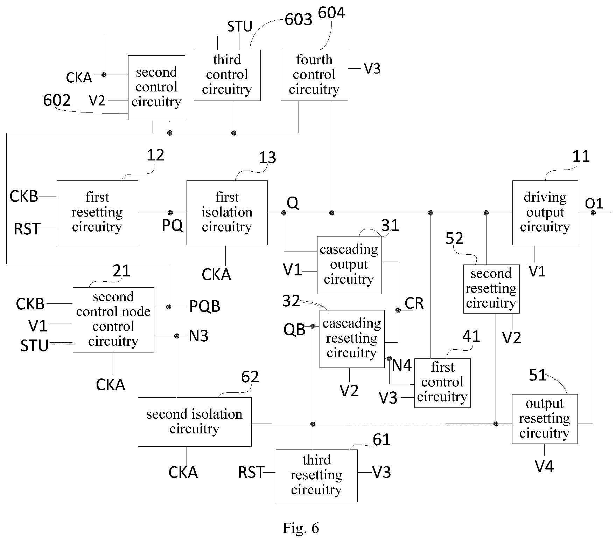

As shown in Fig. 6, on the basis of the driving circuitry in Fig. 5, the driving circuitry further includes a second control circuitry 602, a third control circuitry 603, a fourth control circuitry 604, a third resetting circuitry 61 and a second isolation circuitry 62. The second control circuitry 602 is electrically coupled to the first control node PQ, the second clock signal line CKA, the second voltage line V2 and the second control node PQB, and configured to control the first control node PQ to be electrically coupled to the second voltage line V2 under the control of the potential at the second control node PQB and the second clock signal from the second clock signal line CKA. The third control circuitry 603 is electrically coupled to the second clock signal line CKA, the input line STU and the first control node PQ, and configured to control the input line STU to be electrically coupled to the first control node PQ under the control of the second clock signal CKA. The fourth control circuitry 604 is electrically coupled to the first node Q, the first control node PQ and the third voltage line V3, and configured to control the first control node PQ to be electrically coupled to the third voltage line V3 under the control of the potential at the first node Q. The second control node control circuitry 21 is further electrically coupled to the input line STU and the first clock signal line CKB, and configured to write the first clock signal from the first clock signal line CKB into the second control node PQB under the control of the input signal from the input line STU. The third resetting circuitry 61 is electrically coupled to the resetting line RST, the third voltage line V3 and the second node QB, and configured to control the third voltage line V3 to be electrically coupled to the second node QB under the control of the resetting signal from the resetting line RST. The second isolation circuitry 62 is electrically coupled to the second clock signal line CKA, the third node N3 and the second node QB, and configured to control the third node N3 to be electrically coupled to the second node QB under the control of the second clock signal from the second clock signal line CKA.

In a possible embodiment of the present disclosure, the third control circuitry includes an eleventh transistor, the second control circuitry includes a twelfth transistor and a thirteenth transistor, and the fourth control circuitry includes a fourteenth transistor. A gate electrode of the eleventh transistor is electrically coupled to the second clock signal line, a first electrode of the eleventh transistor is electrically coupled to the input line, and a second electrode of the eleventh transistor is electrically coupled to the first control node. A gate electrode of the fourteenth transistor is electrically coupled to the first node, a first electrode of the fourteenth transistor is electrically coupled to a third voltage line, and a second electrode of the fourteenth transistor is electrically coupled to the first control node. A gate electrode of the twelfth transistor is electrically coupled to the second clock signal line, a first electrode of the twelfth transistor is electrically coupled to the first control node, a second electrode of the twelfth transistor is electrically coupled to a first electrode of the thirteenth transistor, a gate electrode of the thirteenth transistor is electrically coupled to the second control node, and a second electrode of the thirteenth transistor is electrically coupled to the second voltage line, or the gate electrode of the twelfth transistor is electrically coupled to the second control node, the first electrode of the twelfth transistor is electrically coupled to the first control node, the second electrode of the twelfth transistor is electrically coupled to the first electrode of the thirteenth transistor, the gate electrode of the thirteenth transistor is electrically coupled to the second clock signal line, and the second electrode of the thirteenth transistor is electrically coupled to the second voltage line.

In a possible embodiment of the present disclosure, the driving output circuitry includes a fifteenth transistor and a second capacitor, and the first isolation circuitry includes a sixteenth transistor. A gate electrode of the fifteenth transistor is electrically coupled to the first node, a first electrode of the fifteenth transistor is electrically coupled to the first voltage line, and a second electrode of the fifteenth transistor is electrically coupled to the driving signal output end. A first end of the second capacitor is electrically coupled to the first node, and a second end of the second capacitor is electrically coupled to the driving signal output end. A control electrode of the sixteenth transistor is electrically coupled to the second clock signal line, a first electrode of the sixteenth transistor is electrically coupled to the first control node, and a second electrode of the sixteenth transistor is electrically coupled to the first node.

In a possible embodiment of the present disclosure, the second control node control circuitry includes a seventeenth transistor, a third capacitor and an eighteenth transistor. A gate electrode of the seventeenth transistor is electrically coupled to the first clock signal line, a first electrode of the seventeenth transistor is electrically coupled to the first voltage line, and a second electrode of the seventeenth transistor is electrically coupled to the second control node. A first end of the third capacitor is electrically coupled to the second control node, and a second end of the third capacitor is electrically coupled to the third node. A gate electrode of the eighteenth transistor is electrically coupled to the second control node, a first electrode of the eighteenth transistor is electrically coupled to the second clock signal line, and a second electrode of the eighteenth transistor is electrically coupled to the third node.

In a possible embodiment of the present disclosure, the cascading output circuitry includes a nineteenth transistor, a gate electrode of the nineteenth transistor is electrically coupled to the first node, a first electrode of the nineteenth transistor is electrically coupled to the first voltage line, and a second electrode of the nineteenth transistor is electrically coupled to a cascading output end.

In at least one embodiment of the present disclosure, the cascading output circuitry further includes a fourth capacitor, a first end of the fourth capacitor is electrically coupled to the first node, and a second end of the fourth capacitor is electrically coupled to the cascading output end.

In a possible embodiment of the present disclosure, the second isolation circuitry includes a twentieth transistor, a gate electrode of the twentieth transistor is electrically coupled to the second clock signal line, a first electrode of the twentieth transistor is electrically coupled to the third node, and a second electrode of the twentieth transistor is electrically coupled to the second node.

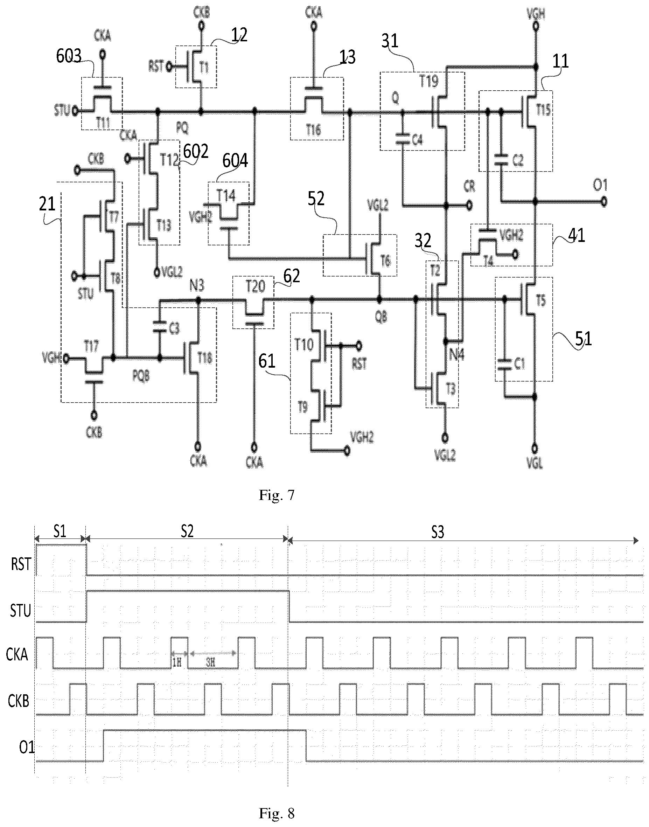

As shown in Fig. 7, on the basis of the driving circuitry in Fig. 6, the first resetting circuitry 12 includes a first transistor T1, a gate electrode of the first transistor T1 is electrically coupled to the resetting line RST, a source electrode of the first transistor T1 is electrically coupled to the first clock signal line CKB, and a drain electrode of the first transistor T1 is electrically coupled to the first control node PQ.

The cascading resetting circuitry 32 includes a second transistor T2 and a third transistor T3. A gate electrode of the second transistor T2 is electrically coupled to the second node QB, a source electrode of the second transistor T2 is electrically coupled to the carry output end CR, and a drain electrode of the second transistor T2 is electrically coupled to the fourth node N4. A gate electrode of the third transistor T3 is electrically coupled to the second node QB, a source electrode of the third transistor T3 is electrically coupled to the fourth node N4, and a drain electrode of the third transistor T3 is electrically coupled to a second low voltage line VGL2.

The first control circuitry 41 includes a fourth transistor T4, a gate electrode of the fourth transistor T4 is electrically coupled to the first node Q, the source electrode of the fourth transistor T4 is electrically coupled to the second high voltage line VGH2, and the drain electrode of the fourth transistor T4 is electrically coupled to the fourth node N4.

The output resetting circuitry 51 includes a fifth transistor T5 and a first capacitor C1, and the second resetting circuitry 52 includes a sixth transistor T6. A gate electrode of the fifth transistor T5 is electrically coupled to the second node QB, the source electrode of the fifth transistor T5 is electrically coupled to the driving signal output end O1, and the drain electrode of the fifth transistor T5 is electrically coupled to the first low voltage line VGL. A first end of the first capacitor C1 is electrically coupled to the second node QB, and a second end of the first capacitor C1 is electrically coupled to the first low voltage line VGL. A gate electrode of the sixth transistor T6 is electrically coupled to the first node Q, a source electrode of the sixth transistor T6 is electrically coupled to the second low voltage line VGL2, and a drain electrode of the sixth transistor T6 is electrically coupled to the second node QB.

The second control node control circuitry 21 includes a seventh transistor T7 and an eighth transistor T8. A gate electrode of the seventh transistor T7 is electrically coupled to the input line STU, a source electrode of the seventh transistor T7 is electrically coupled to the first clock signal line CKB, and a drain electrode of the seventh transistor T7 is electrically coupled to a source electrode of the eighth transistor T8. A gate electrode of the eighth transistor T8 is electrically coupled to the input line STU, and a drain electrode of the eighth transistor T8 is electrically coupled to the second control node PQB.

The third resetting circuitry 61 includes a ninth transistor T9 and a tenth transistor T10. A gate electrode of the ninth transistor T9 is electrically coupled to the resetting line RST, a source electrode of the ninth transistor T9 is electrically coupled to a second high voltage line VGH2, and a drain electrode of the ninth transistor T9 is electrically coupled to a source electrode of the tenth transistor T10. A gate electrode of the tenth transistor T10 is electrically coupled to the resetting line RST, and a drain electrode of the tenth transistor T10 is electrically coupled to the second node QB.

The third control circuitry 603 includes an eleventh transistor T11, the second control circuitry 602 includes a twelfth transistor T12 and a thirteenth transistor T13, and the fourth control circuitry 604 includes a fourteenth transistor T14. A gate electrode of the eleventh transistor T11 is electrically coupled to the second clock signal line CKA, a source electrode of the eleventh transistor T11 is electrically coupled to the input line STU, and a drain electrode of the eleventh transistor T11 is electrically coupled to the first control node PQ. A gate electrode of the fourteenth transistor T14 is electrically coupled to the first node Q, a source electrode of the fourteenth transistor T14 is electrically coupled to the second high voltage line VGH2, and a drain electrode of the fourteenth transistor T14 is electrically coupled to the first control node PQ. A gate electrode of the twelfth transistor T12 is electrically coupled to the second clock signal line CKA, a source electrode of the twelfth transistor T12 is electrically coupled to the first control node PQ, and a drain electrode of the twelfth transistor T12 is electrically coupled to a source electrode of the thirteenth transistor T13. A gate electrode of the thirteenth transistor T13 is electrically coupled to the second control node PQB, and a drain electrode of the thirteenth transistor T13 is electrically coupled to the second low voltage line VGL2.

The driving output circuitry 11 includes a fifteenth transistor T15 and a second capacitor C2, and the first isolation circuitry 13 includes a sixteenth transistor T16. A gate electrode of the fifteenth transistor T15 is electrically coupled to the first node Q, a source electrode of the fifteenth transistor T15 is electrically coupled to the first high voltage line VGH, and a drain electrode of the fifteenth transistor T15 is electrically coupled to the driving signal output end O1. A first end of the second capacitor C2 is electrically coupled to the first node Q, and a second end of the second capacitor C2 is electrically coupled to the driving signal output end O1. A gate electrode of the sixteenth transistor T16 is electrically coupled to the second clock signal line CKA, a source electrode of the sixteenth transistor T16 is electrically coupled to the first control node PQ, and a drain electrode of the sixteenth transistor is electrically coupled to the first node Q.

The second control node control circuitry 21 further includes a seventeenth transistor T17, a third capacitor C3 and an eighteenth transistor T18. A gate electrode of the seventeenth transistor T17 is electrically coupled to the first clock signal line CKB, a source electrode of the seventeenth transistor T17 is electrically coupled to the first high voltage line VGH, and a drain electrode of the seventeenth transistor T17 is electrically coupled to the second control node PQB. A first end of the third capacitor C3 is electrically coupled to the second control node PQB, and a second end of the third capacitor C3 is electrically coupled to the third node N3. A gate electrode of the eighteenth transistor T18 is electrically coupled to the second control node PQB, a source electrode of the eighteenth transistor T18 is electrically coupled to the second clock signal line CKA, and a drain electrode of the eighteenth transistor T18 is electrically coupled to the third node N3.

The cascading output circuitry 31 includes a nineteenth transistor T19, a gate electrode of the nineteenth transistor T19 is electrically coupled to the first node Q, a source electrode of the nineteenth transistor T19 is electrically coupled to the first high voltage line VGH, and a drain electrode of the nineteenth transistor T19 is electrically coupled to the cascading output end CR.

The cascade output circuitry 31 further includes a fourth capacitor C4, a first end of the fourth capacitor C4 is electrically coupled to the first node Q, and a second end of the fourth capacitor C4 is electrically coupled to the cascading output end CR.

The second isolation circuitry 62 includes a twentieth transistor T20, a gate electrode of the twentieth transistor T20 is electrically coupled to the second clock signal line CKA, a source electrode of the twentieth transistor T20 is electrically coupled to the third node N3, and a drain electrode of the twentieth transistor T20 is electrically coupled to the second node QB.

In the driving circuitry in Fig. 7, all of the transistors are, but not limited to, n-type oxide transistors.

In the driving circuitry in Fig. 7, C4 is provided to increase the anti-interference capability.

In the driving circuitry in Fig. 7, the second control node control circuitry includes the seventh transistor T7, the eighth transistor T8, the seventeenth transistor T17, the third capacitor C3 and the eighteenth transistor T18. The drain electrode of T17 is electrically coupled to the gate electrode of T13 in the second control circuitry, and the drain electrode of T18 is electrically coupled to T20. The drain electrode of T18 is electrically coupled to the second node QB through T20, and the drain electrode of T18 is electrically coupled to the gate electrode of T2, the gate electrode of T3 and the electrode of T5.

In at least one embodiment of the present disclosure, the driving circuitry includes, but not limited to, n-type transistors. In actual use, the driving circuitry may also include p-type transistors.

As shown in Fig. 8, during the operation of the driving circuitry in Fig. 7, a drive period includes a first phase S1, a second phase S2 and a third phase S3 arranged one after another.

Within the first phase S1, RST provides a high voltage signal so as to turn on T1. For PQ, when CKB outputs a high voltage signal, the potential at PQ is pulled up. The potential of the second clock signal from CKA is a low voltage and T16 is turned off, so the potential at the first node Q is not pulled up. When CKB outputs a low voltage signal and CKA outputs a high voltage signal, T16 is turned on, and at this time, the potential at PQ and the potential at Q are both pulled down, so as to reset the potential at the first node Q. The potential at PQ changes periodically along with the potential of the first clock signal from CKB, so the low voltage time period is short, and the leakage current is small. In addition, the potential at PQ is reset through T1, so as to further reduce the risk of current leakage.

Within the first phase S1, RST provides a high voltage signal, so as to turn on T9 and T10. QB is electrically coupled to VGH2. VGH2 outputs a second high voltage signal for a long time period, so no current leakage occurs. When CKB outputs a high voltage, T17 is turned on, and the potential at PQB is a high voltage. Due to the presence of C3, the potential at PQB is maintained as a high voltage. When CKA outputs a high voltage signal, the potential at PQB is further pulled up due to bootstrapping, and changes periodically with a change in the potential of the second clock signal from the CKA.

Within the second phase S2, STU provides a high voltage signal and RST provides a low voltage signal. When CKA provides a high voltage signal, T11, T16, T15 and T19 are turned on, the potential at PQ and the potential at Q are high voltages. Each of CR and O1 outputs a high voltage signal, T7 and T8 are turned on, and the potential at PQB changes with a change in the potential of the first clock signal from the CKB. T6 is turned on, and QB is electrically coupled to VGL2.

Within the third phase S3, STU provides a low voltage signal. When CKA outputs a high voltage signal, T11 is turned on, PQ is electrically coupled to STU, and the potential at PQ is a low voltage. T16 is turned on and PQ is electrically coupled to Q, so that the potential at the first node Q is a low voltage. When CKA outputs a high voltage signal, the potential at PQB is pulled up due to bootstrapping, and T20 is turned on. The potential at QB is a high voltage so as to turn on T5 and T2. CR outputs a second low voltage signal, and O1 outputs a low voltage signal.

As shown in Fig. 8, the driving signal outputted by the driving circuitry in Fig. 7 through the driving signal output end is a compensation control signal.

In the driving circuitry in Fig. 7, the potential of the first low voltage signal from VGL is -6 V, and the potential of the second low voltage signal from VGL2 is -8 V. When O1 outputs a high voltage signal, a gate-to-source voltage of T11 is -2 V, so it is able to prevent the occurrence of current leakage when the negative drift occurs for the threshold voltage of T11.

As shown in Fig. 8, a duty ratio of the first clock signal from CKA and a duty ratio of the second clock signal from CKB are, but not limited to, 25%, and a phase of the second clock signal is separated from a phase of the first clock signal by, but not limited to, half a period.

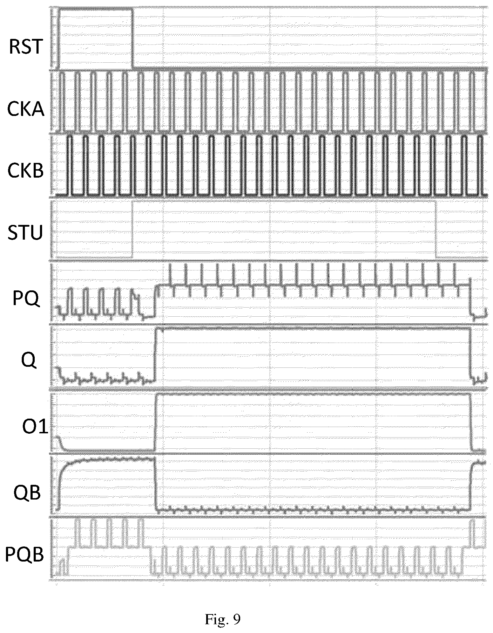

Fig. 9 is a simulated sequence diagram of the driving circuitry in Fig. 7 when a threshold voltage of the oxide transistor is 4 V.

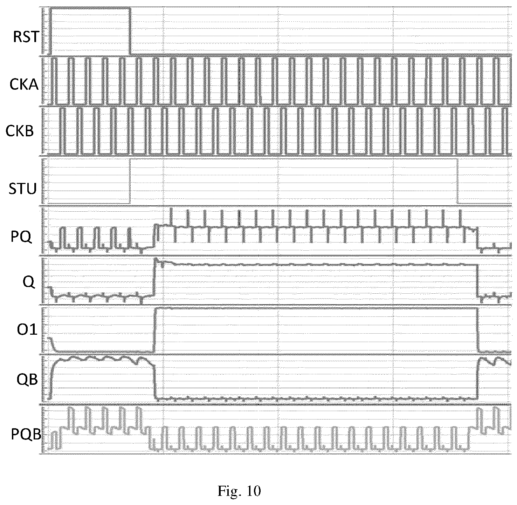

Fig. 10 is a simulated sequence diagram of the driving circuitry in Fig. 7 when the threshold voltage of the oxide transistor is -2.5 V.

As shown in Fig. 10, the driving circuitry in Fig. 7 operates normally when the threshold voltage of the oxide transistor is -2.5V.

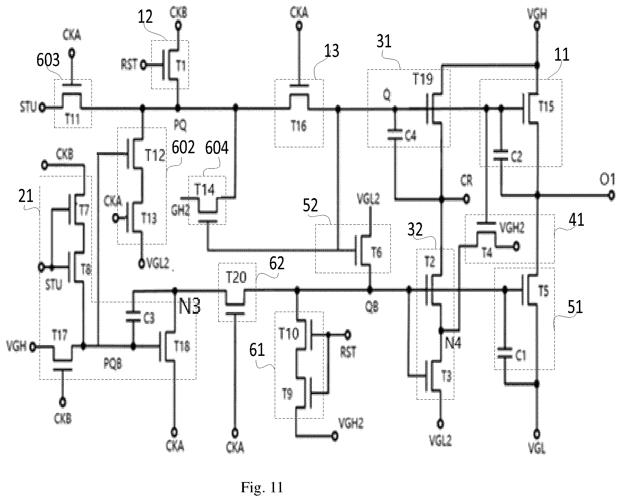

The driving circuitry in Fig. 11 differs from that in Fig. 7 in that the gate electrode of T12 is electrically coupled to PQB, and the gate electrode of T13 is electrically coupled to the second clock signal line CKA.

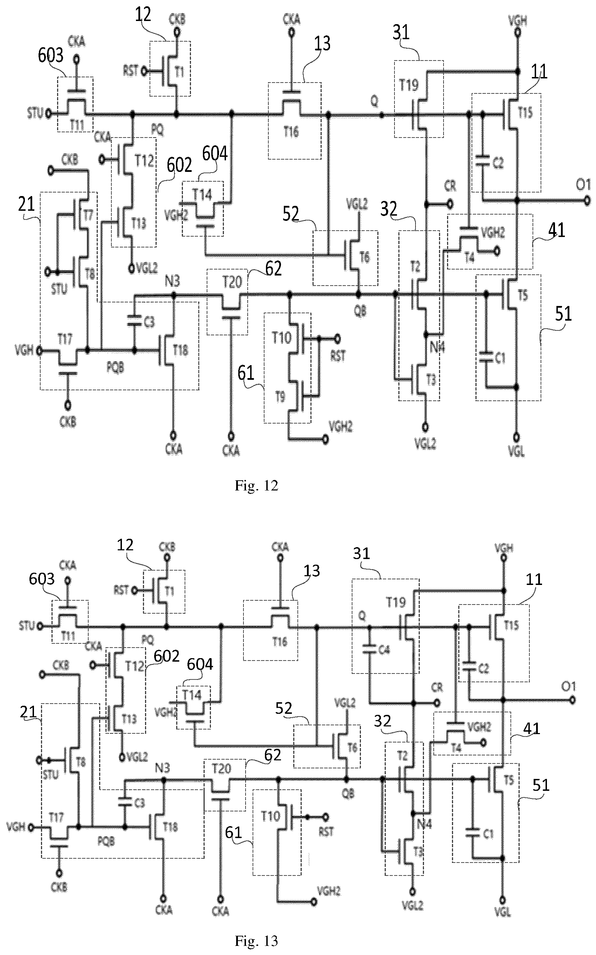

The driving circuitry in Fig. 12 differs from that in Fig. 7 in that C4 is not provided.

The driving circuitry in Fig. 13 differs from that in Fig. 7 in that T7 and T9 are not provided.

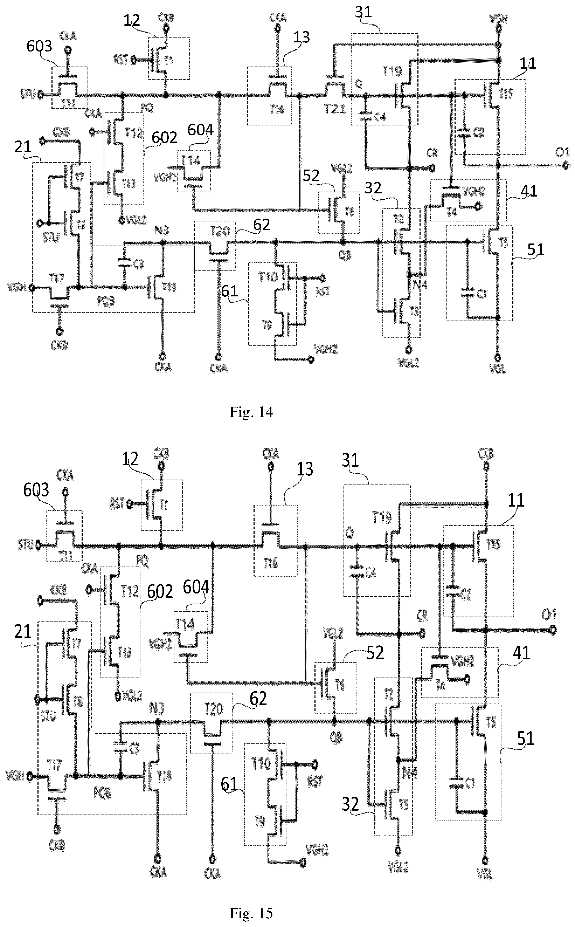

The driving circuitry in Fig. 14 differs from that in Fig. 7 in that the driving circuitry further includes the twenty-first transistor T21, the gate electrode of the twenty-first transistor T21 is electrically coupled to the first high voltage line VGH, the source electrode of the twenty-first transistor T21 is electrically coupled to the drain electrode of T16, and the drain electrode of the twenty-first transistor T21 is electrically coupled to the first node Q. The twenty-first transistor T2 is a normally-on transistor.

The driving circuitry in Fig. 15 differs from that in Fig. 7 in that the source electrode of T15 is electrically coupled to the first clock signal line CKB.

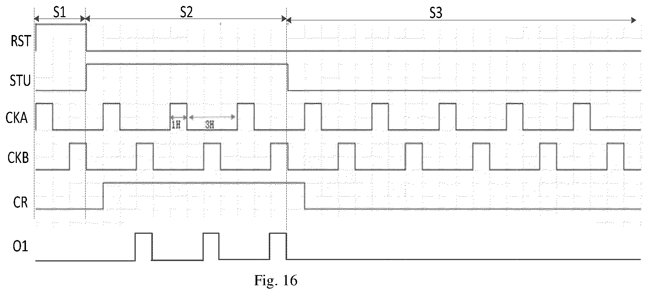

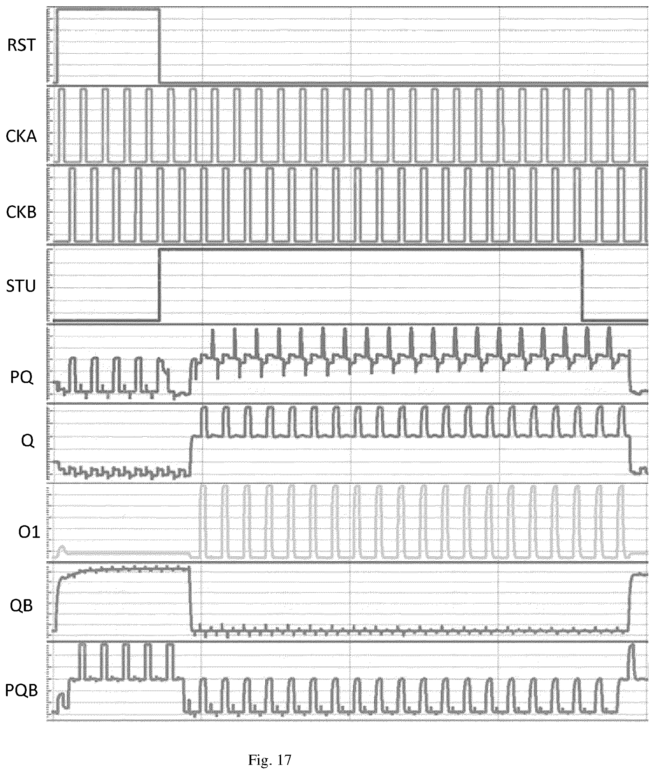

Fig. 16 is a sequence diagram of the driving circuitry in Fig. 15, and Fig. 17 is a simulated sequence diagram of the driving circuitry in Fig. 15.

The driving circuitry in Fig. 15 is configured to, but not limited to, apply a gate driving signal to a pixel unit.

In the driving circuitry in Fig. 15, the driving output circuitry further includes at least two transistors for outputting. For example, apart from the fifteenth transistor, the driving output circuitry further includes at least one output transistor, a source electrode of the output transistor is electrically coupled to a corresponding clock signal output end, and a drain electrode of the output transistor is electrically coupled to a corresponding driving signal output end. At this time, the driving circuitry includes at least two driving signal output ends. A corresponding gate driving signal can be output to the at least two driving signal output ends configured to apply gate driving signals to pixel units in at least two rows.

The present disclosure further provides in some embodiments a driving method for the above-mentioned driving circuitry. A display period includes a first phase, a second phase and a third phase arranged one after another. The driving method includes: within the first phase, controlling, by the first resetting circuitry, the first clock signal line to write the first clock signal into the first control node under the control of the first resetting signal from the first resetting line, and when the second clock signal line provides a high voltage signal, controlling, by the first isolation circuitry, the first control node to be electrically coupled to the first node under the control of the second clock signal from the second clock signal line; within the second phase, when the second clock signal line provides a high voltage signal, controlling, by the first isolation circuitry, the first control node to be electrically coupled to the first node under the control of the second clock signal, and controlling, by the driving output circuitry, the driving signal output end to be electrically coupled to the first voltage line under the control of the potential at the first node; and within the third phase, when the second clock signal line provides a high voltage signal, controlling, by the first isolation circuitry, the first control node to be electrically coupled to the first node under the control of the second clock signal.

The present disclosure further provides in some embodiments a display substrate including the above-mentioned driving circuitry.

The display substrate further includes a plurality of direct-current signal lines arranged in columns, a display region and a peripheral region, and the direct-current signal lines and the driving circuitry are arranged in the peripheral region. The direct-current signal lines in at least one column are arranged on a side of the driving circuitry away from the display region, and the direct-current signal lines other than the direct-current signal lines in the at least one column are arranged on a side of the driving circuitry close to the display region.

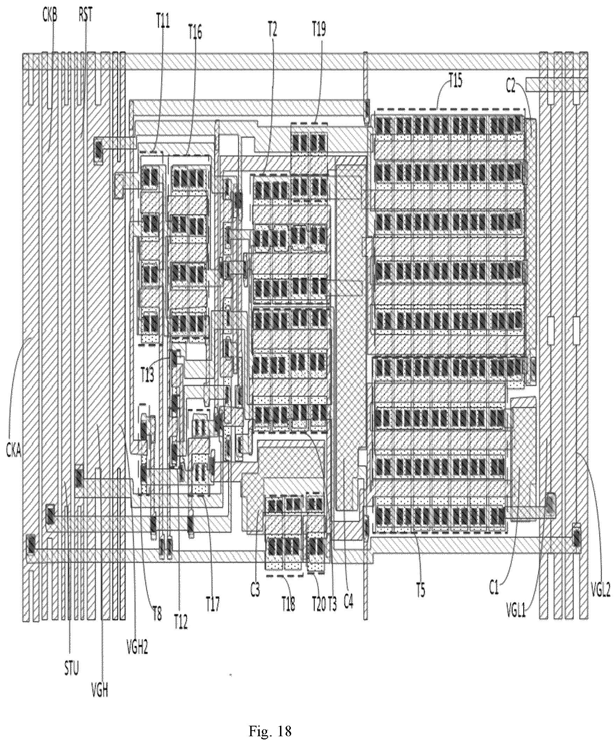

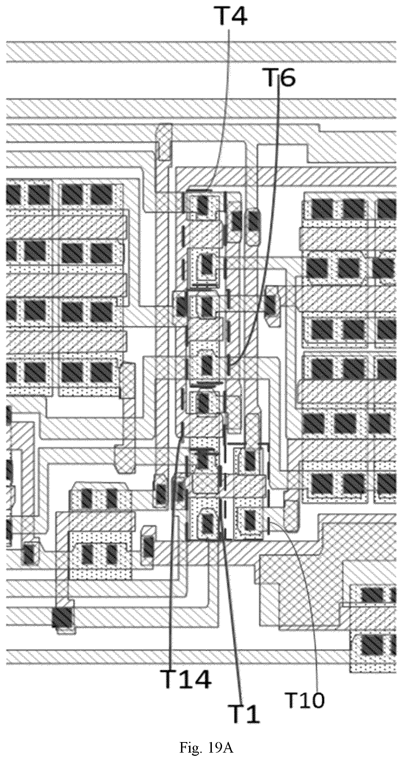

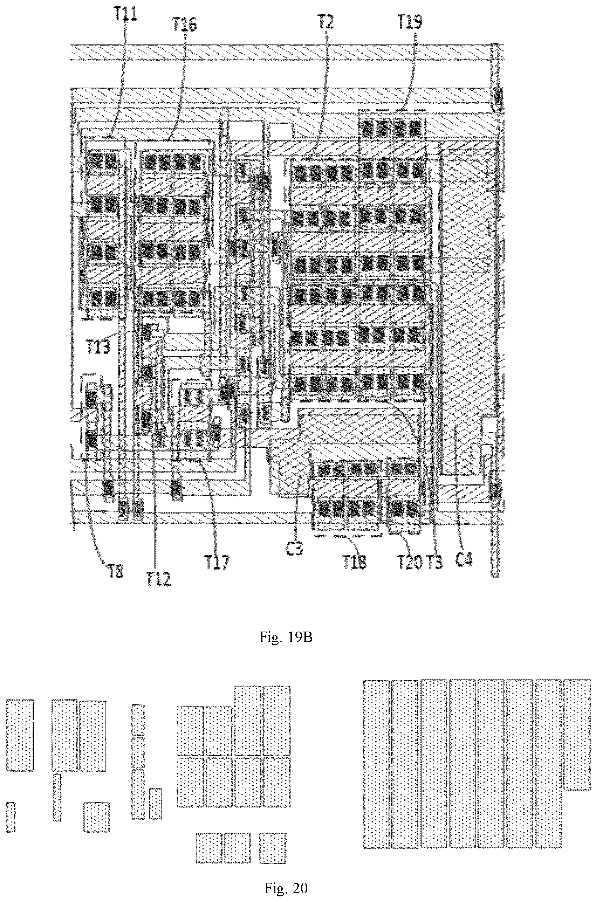

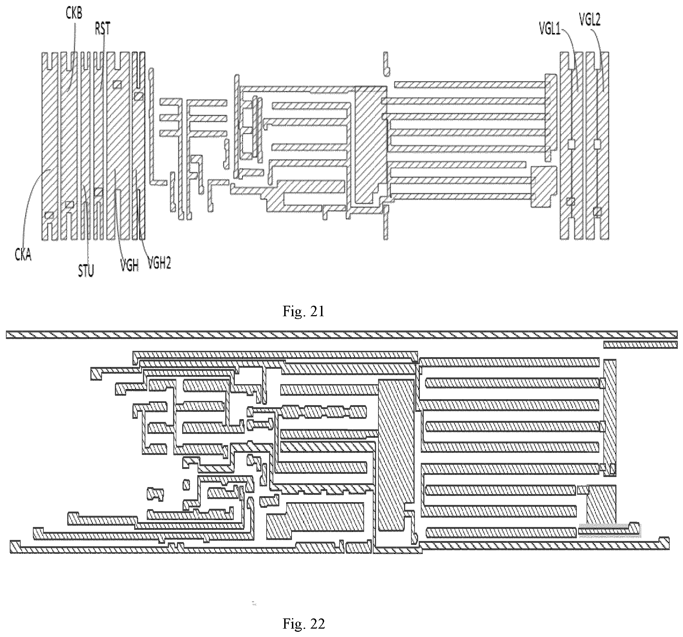

Fig. 18 is a schematic view showing the layout of the driving circuitry in Fig. 13, Figs. 19A and 19B are enlarged views of the driving circuitry in Fig. 18, Fig. 20 is a schematic view showing the layout of a semiconductor layer in Fig. 18, Fig. 21 is a schematic view showing the layout of a gate metal layer in Fig. 18, and Fig. 22 is a schematic view showing the layout of a source/drain metal layer in Fig. 18.

As shown in Fig. 18, CKA, CKB, STU, RST, VGH and VGH2 extend in a vertical direction, and VGL1 and VGL2 extend in the vertical direction. CKA, CKB, STU, RST, VGH and VGH2 are arranged on a side of the driving circuitry away from the display region, and VGL1 and VGL2 are arranged on a side of the driving circuitry close to the display region.

As shown in Fig. 18, a plate of the fourth capacitor C4 extends in the vertical direction, an area of the plate of the fourth capacitor C4 is larger than an area of a plate of the first capacitor C1, an area of a plate of C2, and an area of a plate of C3.

The present disclosure further provides in some embodiments a display device including the above-mentioned display substrate.

The display device may be any product or member having a display function, e.g., mobile phone, tablet computer, television, display, laptop computer, digital photo frame or navigator.

The above embodiments are for illustrative purposes only, but the present disclosure is not limited thereto. Obviously, a person skilled in the art may make further modifications and improvements without departing from the scope of the claimed invention as defined in the appended claims.

## Claims

1. A display device, comprising a gate driving circuitry, wherein the gate driving circuitry comprises a driving output circuitry (11), a first resetting circuitry (12) and a first isolation circuitry (13), wherein
the driving output circuitry (11) is electrically coupled to a first node (Q) and a driving signal output end (O1), electrically coupled to a first voltage line (V1) or a first clock signal line (CKB), and configured to control the driving signal output end (O1) to be electrically coupled to the first voltage line (V1) or the first clock signal line (CKB) under the control of a potential at the first node (Q); the driving output circuitry (11) comprises a fifteenth transistor (T15) and a second capacitor (C2); a gate electrode of the fifteenth transistor (T15) is electrically coupled to the first node (Q), a first electrode of the fifteenth transistor (T15) is electrically coupled to the first voltage line (V1) or the first clock signal line (CKB), and a second electrode of the fifteenth transistor (T15) is electrically coupled to the driving signal output end (O1); a first end of the second capacitor (C2) is electrically coupled to the first node (Q), and a second end of the second capacitor (C2) is electrically coupled to the driving signal output end (O1);
wherein,
the first resetting circuitry (12) is electrically coupled to a first resetting line, the first clock signal line (CKB) and a first control node (PQ), and configured to control the first clock signal line (CKB) to write a first clock signal into the first control node (PQ) under the control of a first resetting signal from the first resetting line; the first resetting circuitry (12) comprises a first transistor (T1), a gate electrode of the first transistor (T1) is electrically coupled to the first resetting line, a first electrode of the first transistor (T1) is electrically coupled to the first clock signal line (CKB), and a second electrode of the first transistor (T1) is electrically coupled to the first control node (PQ),
the first isolation circuitry (13) is electrically coupled to a second clock signal line (CKA), the first control node (PQ) and the first node (Q), and configured to control the first control node (PQ) to be electrically coupled to the first node (Q) under the control of a second clock signal from the second clock signal line (CKA); the first isolation circuitry (13) comprises a sixteenth transistor (T16); a control electrode of the sixteenth transistor (T16) is electrically coupled to the second clock signal line (CKA), a first electrode of the sixteenth transistor (T16) is electrically coupled to the first control node (PQ), and a second electrode of the sixteenth transistor (T16) is electrically coupled to the first node (Q);
wherein the gate driving circuitry further comprises a second control node control circuitry (21) coupled to the first clock signal line (CKB), the first voltage line (V1), a second control node (PQB), a third node (N3) and the second clock signal line (CKA), and configured to control the second control node (PQB) to be electrically coupled to the first voltage line (V1) under the control of the first clock signal, and control the third node (N3) to be electrically coupled to the second clock signal line (CKA) under the control of a potential at the second control node (PQB),
wherein the second control node control circuitry (21) is further configured to control the potential at the second control node (PQB) in accordance with a potential at the third node (N3);
wherein the second control node control circuitry (21) is further electrically coupled to the input line (STU), and configured to write the first clock signal into the second control node (PQB) under the control of an input signal from the input line (STU),
wherein the second control node control circuitry (21) comprises a seventh transistor (T7) and an eighth transistor (T8); a gate electrode of the seventh transistor (T7) is electrically coupled to the input line (STU), a first electrode of the seventh transistor (T7) is electrically coupled to the first clock signal line (CKB), and a second electrode of the seventh transistor (T7) is electrically coupled to a first electrode of the eighth transistor (T8); and a gate electrode of the eighth transistor (T8) is electrically coupled to the input line (STU), and a second electrode of the eighth transistor (T8) is electrically coupled to the second control node (PQB); and
wherein the second control node control circuitry (21) further comprises a seventeenth transistor (T17), a third capacitor (C3) and an eighteenth transistor (T18); a gate electrode of the seventeenth transistor (T17) is electrically coupled to the first clock signal line (CKB), a first electrode of the seventeenth transistor (T17) is electrically coupled to the first voltage line (V1), and a second electrode of the seventeenth transistor (T17) is electrically coupled to the second control node (PQB); a first end of the third capacitor (C3) is electrically coupled to the second control node (PQB), and a second end of the third capacitor (C3) is electrically coupled to the third node (N3); and a gate electrode of the eighteenth transistor (T18) is electrically coupled to the second control node (PQB), a first electrode of the eighteenth transistor (T18) is electrically coupled to the second clock signal line (CKA), and a second electrode of the eighteenth transistor (T18) is electrically coupled to the third node (N3).

2. The display device according to claim 1,
wherein the first transistor (T1) is an oxide thin film transistor, a first high voltage time period does not overlap with a second high voltage time period, the first high voltage time period is a time period within which a potential of the first clock signal is a high voltage, and the second high voltage time period is a time period within which a potential of the second clock signal is a high voltage.

3. The display device according to claim 1 or 2,
wherein the gate driving circuitry further comprises a cascading output circuitry (31) and a cascading resetting circuitry (32), wherein the cascading output circuitry (31) is electrically coupled to the first node (Q), a carry output end (CR) and the first voltage line (V1), and configured to control the carry output end (CR) to be electrically coupled to the first voltage line (V1) under the control of the potential at the first node (Q), and the cascading resetting circuitry (32) is electrically coupled to a second node (QB), the carry output end (CR) and a second voltage line (V2), and configured to control the carry output end (CR) to be electrically coupled to the second voltage line (V2) under the control of a potential at the second node (QB),
wherein the cascading resetting circuitry (32) comprises a second transistor (T2) and a third transistor (T3);
a gate electrode of the second transistor (T2) is electrically coupled to the second node (QB), a first electrode of the second transistor (T2) is electrically coupled to the carry output end (CR), and a second electrode of the second transistor (T2) is electrically coupled to a fourth node (N4); and
a gate electrode of the third transistor (T3) is electrically coupled to the second node (QB), a first electrode of the third transistor (T3) is electrically coupled to the fourth node (N4), and a second electrode of the third transistor (T3) is electrically coupled to the second voltage line (V2),
wherein the gate driving circuitry further comprises a first control circuitry (41) electrically coupled to the first node (Q), a third voltage line (V3) and the fourth node (N4), and configured to control the third voltage line (V3) to be electrically coupled to the fourth node (N4) under the control of the potential at the first node (Q),
wherein the first control circuitry (41) comprises a fourth transistor (T4), a gate electrode of the fourth transistor (T4) is electrically coupled to the first node (Q), a first electrode of the fourth transistor (T4) is electrically coupled to the third voltage line (V3), and a second electrode of the fourth transistor (T4) is electrically coupled to the fourth node (N4).

4. The display device according to claim 1 or 2, further comprising an output resetting circuitry (51) and a second resetting circuitry (52), wherein the output resetting circuitry (51) is electrically coupled to the second node (QB), the driving signal output end (O1) and a fourth voltage line (V4), and configured to control the driving signal output end (O1) to be electrically coupled to the fourth voltage line (V4) under the control of the potential at the second node (QB), wherein the second resetting circuitry (52) is electrically coupled to the first node (Q), the second voltage line (V2) and the second node (QB), and configured to control the second voltage line (V2) to be electrically coupled to the second node (QB) under the control of the potential at the first node (Q),
wherein a transistor in the output resetting circuitry (51) is an oxide transistor, and a voltage value of a second voltage signal from the second voltage line (V2) is less than a voltage value of a first voltage signal from the first voltage line (V1),
wherein the output resetting circuitry (51) comprises a fifth transistor (T5) and a first capacitor (C1), and the second resetting circuitry (52) comprises a sixth transistor (T6);
a gate electrode of the fifth transistor (T5) is electrically coupled to the second node (QB), a first electrode of the fifth transistor (T5) is electrically coupled to the driving signal output end (O1), and a second electrode of the fifth transistor (T5) is electrically coupled to the fourth voltage line (V4);
a first end of the first capacitor (C1) is electrically coupled to the second node (QB), and a second end of the first capacitor (C1) is electrically coupled to the fourth voltage line (V4); and
a gate electrode of the sixth transistor (T6) is electrically coupled to the first node (Q), a first electrode of the sixth transistor (T6) is electrically coupled to the second voltage line (V2), and a second electrode of the sixth transistor (T6) is electrically coupled to the second node (QB),
wherein the gate driving circuitry further comprises a second control circuitry (602) electrically coupled to the first control node (PQ), the second clock signal line (CKA), the second voltage line (V2) and the second control node (PQB), and configured to control the first control node (PQ) to be electrically coupled to the second voltage line (V2) under the control of the potential at the second control node (PQB) and the second clock signal from the second clock signal line (CKA),
wherein the gate driving circuitry further comprises a third control circuitry (603) electrically coupled to the second clock signal line (CKA), an input line (STU) and the first control node (PQ), and configured to control the input line (STU) to be electrically coupled to the first control node (PQ) under the control of the second clock signal,
wherein the gate driving circuitry further comprises a fourth control circuitry (604) electrically coupled to the first node (Q), the first control node (PQ) and the third voltage line (V3), and configured to control the first control node (PQ) to be electrically coupled to the third voltage line (V3) under the control of the potential at the first node (Q).

5. The display device according to claim 4, further comprising a third resetting circuitry (61) electrically coupled to a second resetting line, the third voltage line (V3), and the second node (QB), and configured to control the third voltage line (V3) to be electrically coupled to the second node (QB) under the control of a second resetting signal from the second resetting line,
wherein the third resetting circuitry (61) comprises a ninth transistor (T9) and a tenth transistor (T10);
a gate electrode of the ninth transistor (T9) is electrically coupled to the second resetting line, a first electrode of the ninth transistor (T9) is electrically coupled to the third voltage line (V3), and a second electrode of the ninth transistor (T9) is electrically coupled to a first electrode of the tenth transistor (T10); and
a gate electrode of the tenth transistor (T10) is electrically coupled to the second resetting line, and a second electrode of the tenth transistor (T10) is electrically coupled to the second node (QB).

6. The display device according to claim 3, further comprising a second isolation circuitry (62) electrically coupled to the second clock signal line (CKA), the third node (N3) and the second node (QB), and configured to control the third node (N3) to be electrically coupled to the second node (QB) under the control of a second clock signal from the second clock signal line (CKA).

7. The display device according to claim 4, wherein the third control circuitry (603) comprises an eleventh transistor (T11), the second control circuitry (602) comprises a twelfth transistor (T12) and a thirteenth transistor (T13), and the fourth control circuitry (604) comprises a fourteenth transistor (T14);
a gate electrode of the eleventh transistor (T11) is electrically coupled to the second clock signal line (CKA), a first electrode of the eleventh transistor (T11) is electrically coupled to the input line (STU), and a second electrode of the eleventh transistor (T11) is electrically coupled to the first control node (PQ);
a gate electrode of the fourteenth transistor (T14) is electrically coupled to the first node (Q), a first electrode of the fourteenth transistor (T14) is electrically coupled to a third voltage line (V3), and a second electrode of the fourteenth transistor (T14) is electrically coupled to the first control node (PQ);
a gate electrode of the twelfth transistor (T12) is electrically coupled to the second clock signal line (CKA), a first electrode of the twelfth transistor (T12) is electrically coupled to the first control node (PQ), a second electrode of the twelfth transistor (T12) is electrically coupled to a first electrode of the thirteenth transistor (T13), a gate electrode of the thirteenth transistor (T13) is electrically coupled to the second control node (PQB), and a second electrode of the thirteenth transistor (T13) is electrically coupled to the second voltage line (V2), or
the gate electrode of the twelfth transistor (T12) is electrically coupled to the second control node (PQB), the first electrode of the twelfth transistor (T12) is electrically coupled to the first control node (PQ), the second electrode of the twelfth transistor (T12) is electrically coupled to the first electrode of the thirteenth transistor (T13), the gate electrode of the thirteenth transistor (T13) is electrically coupled to the second clock signal line (CKA), and the second electrode of the thirteenth transistor (T13) is electrically coupled to the second voltage line (V2).

8. The display device according to claim 3,
wherein the cascading output circuitry (31) comprises a nineteenth transistor (T19), a gate electrode of the nineteenth transistor (T19) is electrically coupled to the first node (Q), a first electrode of the nineteenth transistor (T19) is electrically coupled to the first voltage line (V1), and a second electrode of the nineteenth transistor (T19) is electrically coupled to a cascading output end (CR),
wherein the cascading output circuitry (31) further comprises a fourth capacitor (C4), a first end of the fourth capacitor (C4) is electrically coupled to the first node (Q), and a second end of the fourth capacitor (C4) is electrically coupled to the cascading output end (CR).

9. The display device according to claim 6, wherein the second isolation circuitry (62) comprises a twentieth transistor (T20), a gate electrode of the twentieth transistor (T20) is electrically coupled to the second clock signal line (CKA), a first electrode of the twentieth transistor (T20) is electrically coupled to the third node (N3), and a second electrode of the twentieth transistor (T20) is electrically coupled to the second node (QB).

10. The display device according to claim 1, wherein the gate driving circuitry further comprises a twenty-first transistor (T21), a gate electrode of the twenty-first transistor (T21) is electrically coupled to a first high voltage line (VGH), a first electrode of the twenty-first transistor (T21) is electrically coupled to the second electrode of the sixteenth transistor (T16), and a second electrode of the twenty-first transistor (T21) is electrically coupled to the first node (Q).

11. A driving method for the display device according to any one of claims 1 to 10, a display period comprising a first phase (S1), a second phase (S2) and a third phase (S3) arranged one after another, the driving method comprising:
within the first phase (S1), controlling, by the first resetting circuitry (12), the first clock signal line (CKB) to write the first clock signal into the first control node (PQ) under the control of the first resetting signal from the first resetting line, and when the second clock signal line (CKA) provides a high voltage signal, controlling, by the first isolation circuitry (13), the first control node (PQ) to be electrically coupled to the first node (Q) under the control of the second clock signal from the second clock signal line (CKA);
within the second phase (S2), when the second clock signal line (CKA) provides a high voltage signal, controlling, by the first isolation circuitry (13), the first control node (PQ) to be electrically coupled to the first node (Q) under the control of the second clock signal, and controlling, by the driving output circuitry (11), the driving signal output end (O1) to be electrically coupled to the first voltage line (V1) under the control of the potential at the first node (Q); and
within the third phase (S3), when the second clock signal line (CKA) provides a high voltage signal, controlling, by the first isolation circuitry (13), the first control node (PQ) to be electrically coupled to the first node (Q) under the control of the second clock signal.

12. The display device of claims 1 to 10, comprising a display substrate, wherein the display substrate further comprises a plurality of direct-current signal lines arranged in columns, a display region and a peripheral region, wherein the direct-current signal lines and the gate driving circuitry are arranged in the peripheral region, the direct-current signal lines in at least one column are arranged on a side of the gate driving circuitry away from the display region, and the direct-current signal lines other than the direct-current signal lines in the at least one column are arranged on a side of the gate driving circuitry close to the display region.

## Patentansprüche

1. Anzeigevorrichtung, umfassend eine Gate-Ansteuerschaltung, wobei die Gate-Ansteuerschaltung eine Ansteuer-Ausgangsschaltung (11), eine erste Rücksetzschaltung (12) und eine erste Trennschaltung (13) umfasst, wobei
die Ansteuer-Ausgangsschaltung (11) elektrisch mit einem ersten Knoten (Q) und einem Ansteuersignal-Ausgangsende (O1) gekoppelt ist, elektrisch mit einer ersten Spannungsleitung (V1) oder einer ersten Taktsignalleitung (CKB) gekoppelt ist und dazu eingerichtet ist, das Ansteuersignal-Ausgangsende (O1) so zu steuern, dass es unter der Steuerung eines Potentials an dem ersten Knoten (Q) elektrisch mit der ersten Spannungsleitung (V1) oder der ersten Taktsignalleitung (CKB) gekoppelt wird; die Ansteuer-Ausgangsschaltung (11) einen fünfzehnten Transistor (T15) und einen zweiten Kondensator (C2) umfasst; eine Gate-Elektrode des fünfzehnten Transistors (T15) elektrisch mit dem ersten Knoten (Q) gekoppelt ist, eine erste Elektrode des fünfzehnten Transistors (T15) elektrisch mit der ersten Spannungsleitung (V1) oder der ersten Taktsignalleitung (CKB) gekoppelt ist und eine zweite Elektrode des fünfzehnten Transistors (T15) elektrisch mit dem Ansteuersignal-Ausgangsende (O1) gekoppelt ist; ein erstes Ende des zweiten Kondensators (C2) elektrisch mit dem ersten Knoten (Q) gekoppelt ist und ein zweites Ende des zweiten Kondensators (C2) elektrisch mit dem Ansteuersignal-Ausgangsende (O1) gekoppelt ist;
wobei
die erste Rücksetzschaltung (12) elektrisch mit einer ersten Rücksetzleitung, der ersten Taktsignalleitung (CKB) und einem ersten Steuerknoten (PQ) gekoppelt ist und dazu eingerichtet ist, die erste Taktsignalleitung (CKB) so zu steuern, dass sie unter der Steuerung eines ersten Rücksetzsignals von der ersten Rücksetzleitung ein erstes Taktsignal in den ersten Steuerknoten (PQ) schreibt; die erste Rücksetzschaltung (12) einen ersten Transistor (T1) umfasst, eine Gate-Elektrode des ersten Transistors (T1) elektrisch mit der ersten Rücksetzleitung gekoppelt ist, eine erste Elektrode des ersten Transistors (T1) elektrisch mit der ersten Taktsignalleitung (CKB) gekoppelt ist und eine zweite Elektrode des ersten Transistors (T1) elektrisch mit dem ersten Steuerknoten (PQ) gekoppelt ist,
die erste Trennschaltung (13) elektrisch mit einer zweiten Taktsignalleitung (CKA), dem ersten Steuerknoten (PQ) und dem ersten Knoten (Q) gekoppelt ist und dazu eingerichtet ist, den ersten Steuerknoten (PQ) so zu steuern, dass er unter der Steuerung eines zweiten Taktsignals von der zweiten Taktsignalleitung (CKA) elektrisch mit dem ersten Knoten (Q) gekoppelt wird; die erste Trennschaltung (13) einen sechzehnten Transistor (T16) umfasst; eine Steuerelektrode des sechzehnten Transistors (T16) elektrisch mit der zweiten Taktsignalleitung (CKA) gekoppelt ist, eine erste Elektrode des sechzehnten Transistors (T16) elektrisch mit dem ersten Steuerknoten (PQ) gekoppelt ist und eine zweite Elektrode des sechzehnten Transistors (T16) elektrisch mit dem ersten Knoten (Q) gekoppelt ist;
wobei die Gate-Ansteuerschaltung des Weiteren eine Steuerschaltung (21) für den zweiten Steuerknoten umfasst, die mit der ersten Taktsignalleitung (CKB), der ersten Spannungsleitung (V1), einem zweiten Steuerknoten (PQB), einem dritten Knoten (N3) und der zweiten Taktsignalleitung (CKA) gekoppelt ist und dazu eingerichtet ist, den zweiten Steuerknoten (PQB) so zu steuern, dass er unter der Steuerung des ersten Taktsignals elektrisch mit der ersten Spannungsleitung (V1) gekoppelt wird, und den dritten Knoten (N3) so zu steuern, dass er unter der Steuerung eines Potentials an dem zweiten Steuerknoten (PQB) elektrisch mit der zweiten Taktsignalleitung (CKA) gekoppelt wird,
wobei die Steuerschaltung (21) für den zweiten Steuerknoten des Weiteren dazu eingerichtet ist, das Potential an dem zweiten Steuerknoten (PQB) gemäß einem Potential an dem dritten Knoten (N3) zu steuern;
wobei die Steuerschaltung (21) für den zweiten Steuerknoten des Weiteren elektrisch mit der Eingangsleitung (STU) gekoppelt ist und dazu eingerichtet ist, das erste Taktsignal unter der Steuerung eines Eingangssignals von der Eingangsleitung (STU) in den zweiten Steuerknoten (PQB) zu schreiben,
wobei die Steuerschaltung (21) für den zweiten Steuerknoten einen siebten Transistor (T7) und einen achten Transistor (T8) umfasst; eine Gate-Elektrode des siebten Transistors (T7) elektrisch mit der Eingangsleitung (STU) gekoppelt ist, eine erste Elektrode des siebten Transistors (T7) elektrisch mit der ersten Taktsignalleitung (CKB) gekoppelt ist und eine zweite Elektrode des siebten Transistors (T7) elektrisch mit einer ersten Elektrode des achten Transistors (T8) gekoppelt ist; und eine Gate-Elektrode des achten Transistors (T8) elektrisch mit der Eingangsleitung (STU) gekoppelt ist und eine zweite Elektrode des achten Transistors (T8) elektrisch mit dem zweiten Steuerknoten (PQB) gekoppelt ist; und
wobei die Steuerschaltung (21) für den zweiten Steuerknoten des Weiteren einen siebzehnten Transistor (T17), einen dritten Kondensator (C3) und einen achtzehnten Transistor (T18) umfasst; eine Gate-Elektrode des siebzehnten Transistors (T17) elektrisch mit der ersten Taktsignalleitung (CKB) gekoppelt ist, eine erste Elektrode des siebzehnten Transistors (T17) elektrisch mit der ersten Spannungsleitung (V1) gekoppelt ist, und eine zweite Elektrode des siebzehnten Transistors (T17) elektrisch mit dem zweiten Steuerknoten (PQB) gekoppelt ist; ein erstes Ende des dritten Kondensators (C3) elektrisch mit dem zweiten Steuerknoten (PQB) gekoppelt ist und ein zweites Ende des dritten Kondensators (C3) elektrisch mit dem dritten Knoten (N3) gekoppelt ist; und eine Gate-Elektrode des achtzehnten Transistors (T18) elektrisch mit dem zweiten Steuerknoten (PQB) gekoppelt ist, eine erste Elektrode des achtzehnten Transistors (T18) elektrisch mit der zweiten Taktsignalleitung (CKA) gekoppelt ist und eine zweite Elektrode des achtzehnten Transistors (T18) elektrisch mit dem dritten Knoten (N3) gekoppelt ist.

2. Anzeigevorrichtung nach Anspruch 1,
wobei der erste Transistor (T1) ein Oxiddünnfilmtransistor ist, ein erster Hochspannungszeitraum sich nicht mit einem zweiten Hochspannungszeitraum überlappt, der erste Hochspannungszeitraum ein Zeitraum ist, innerhalb dessen ein Potential des ersten Taktsignals eine Hochspannung ist und der zweite Hochspannungszeitraum ein Zeitraum ist, innerhalb dessen ein Potential des zweiten Taktsignals eine Hochspannung ist.

3. Anzeigevorrichtung nach Anspruch 1 oder 2,
wobei die Gate-Ansteuerschaltung des Weiteren eine Kaskadierungs-Ausgangsschaltung (31) und eine Kaskadierungs-Rücksetzschaltung (32) umfasst, wobei die Kaskadierungs-Ausgangsschaltung (31) elektrisch mit dem ersten Knoten (Q), einem Übertragsausgangsende (CR) und der ersten Spannungsleitung (V1) gekoppelt ist und dazu eingerichtet ist, das Übertragsausgangsende (CR) so zu steuern, dass es unter der Steuerung des Potentials an dem ersten Knoten (Q) elektrisch mit der ersten Spannungsleitung (V1) gekoppelt wird, und die Kaskadierungs-Rücksetzschaltung (32) elektrisch mit einem zweiten Knoten (QB), dem Übertragsausgangsende (CR) und einer zweiten Spannungsleitung (V2) gekoppelt ist und dazu eingerichtet ist, das Übertragsausgangsende (CR) so zu steuern, dass es unter der Steuerung eines Potentials an dem zweiten Knoten (QB) elektrisch mit der zweiten Spannungsleitung (V2) gekoppelt wird,
wobei die Kaskadierungs-Rücksetzschaltung (32) einen zweiten Transistor (T2) und einen dritten Transistor (T3) umfasst;
eine Gate-Elektrode des zweiten Transistors (T2) elektrisch mit dem zweiten Knoten (QB) verbunden ist, eine erste Elektrode des zweiten Transistors (T2) elektrisch mit dem Übertragsausgangsende (CR) verbunden ist und eine zweite Elektrode des zweiten Transistors (T2) elektrisch mit einem vierten Knoten (N4) verbunden ist; und
eine Gate-Elektrode des dritten Transistors (T3) elektrisch mit dem zweiten Knoten (QB) gekoppelt ist, eine erste Elektrode des dritten Transistors (T3) elektrisch mit dem vierten Knoten (N4) gekoppelt ist und eine zweite Elektrode des dritten Transistors (T3) elektrisch mit der zweiten Spannungsleitung (V2) gekoppelt ist,
wobei die Gate-Ansteuerschaltung des Weiteren eine erste Steuerschaltung (41) umfasst, die elektrisch mit dem ersten Knoten (Q), einer dritten Spannungsleitung (V3) und dem vierten Knoten (N4) gekoppelt ist und dazu eingerichtet ist, die dritte Spannungsleitung (V3) so zu steuern, dass sie unter der Steuerung des Potentials an dem ersten Knoten (Q) elektrisch mit dem vierten Knoten (N4) gekoppelt wird,
wobei die erste Steuerschaltung (41) einen vierten Transistor (T4) umfasst, eine Gate-Elektrode des vierten Transistors (T4) elektrisch mit dem ersten Knoten (Q) gekoppelt ist, eine erste Elektrode des vierten Transistors (T4) elektrisch mit der dritten Spannungsleitung (V3) gekoppelt ist und eine zweite Elektrode des vierten Transistors (T4) elektrisch mit dem vierten Knoten (N4) gekoppelt ist.

4. Anzeigevorrichtung nach Anspruch 1 oder 2, des Weiteren umfassend eine Ausgangs-Rücksetzschaltung (51) und eine zweite Rücksetzschaltung (52), wobei die Ausgangs-Rücksetzschaltung (51) elektrisch mit dem zweiten Knoten (QB), dem Ansteuersignal-Ausgangsende (O1) und einer vierten Spannungsleitung (V4) gekoppelt ist und dazu eingerichtet ist, das Ansteuersignal-Ausgangsende (O1) so zu steuern, dass es unter der Steuerung des Potentials an dem zweiten Knoten (QB) elektrisch mit der vierten Spannungsleitung (V4) gekoppelt wird, wobei die zweite Rücksetzschaltung (52) elektrisch mit dem ersten Knoten (Q), der zweiten Spannungsleitung (V2) und dem zweiten Knoten (QB) gekoppelt ist und dazu eingerichtet ist, die zweite Spannungsleitung (V2) so zu steuern, dass sie unter der Steuerung des Potentials an dem ersten Knoten (Q) elektrisch mit dem zweiten Knoten (QB) gekoppelt wird,
wobei ein Transistor in der Ausgangs-Rücksetzschaltung (51) ein Oxidtransistor ist und ein Spannungswert eines zweiten Spannungssignals von der zweiten Spannungsleitung (V2) kleiner ist als ein Spannungswert eines ersten Spannungssignals von der ersten Spannungsleitung (V1),
wobei die Ausgangs-Rücksetzschaltung (51) einen fünften Transistor (T5) und einen ersten Kondensator (C1) umfasst und die zweite Rücksetzschaltung (52) einen sechsten Transistor (T6) umfasst;
eine Gate-Elektrode des fünften Transistors (T5) elektrisch mit dem zweiten Knoten (QB) gekoppelt ist, eine erste Elektrode des fünften Transistors (T5) elektrisch mit dem Ansteuersignal-Ausgangsende (O1) gekoppelt ist,, und eine zweite Elektrode des fünften Transistors (T5) elektrisch mit der vierten Spannungsleitung (V4) gekoppelt ist;
ein erstes Ende des ersten Kondensators (C1) elektrisch mit dem zweiten Knoten (QB) gekoppelt ist und ein zweites Ende des ersten Kondensators (C1) elektrisch mit der vierten Spannungsleitung (V4) gekoppelt ist; und
eine Gate-Elektrode des sechsten Transistors (T6) elektrisch mit dem ersten Knoten (Q) gekoppelt ist, eine erste Elektrode des sechsten Transistors (T6) elektrisch mit der zweiten Spannungsleitung (V2) gekoppelt ist und eine zweite Elektrode des sechsten Transistors (T6) elektrisch mit dem zweiten Knoten (QB) gekoppelt ist,
wobei die Gate-Ansteuerschaltung des Weiteren eine zweite Steuerschaltung (602) umfasst, die elektrisch mit dem ersten Steuerknoten (PQ), der zweiten Taktsignalleitung (CKA), der zweiten Spannungsleitung (V2) und dem zweiten Steuerknoten (PQB) gekoppelt ist und dazu eingerichtet ist, den ersten Steuerknoten (PQ) so zu steuern, dass er unter der Steuerung des Potentials an dem zweiten Steuerknoten (PQB) und des zweiten Taktsignals von der zweiten Taktsignalleitung (CKA) elektrisch mit der zweiten Spannungsleitung (V2) gekoppelt wird,
wobei die Gate-Ansteuerschaltung des Weiteren eine dritte Steuerschaltung (603) umfasst, die elektrisch mit der zweiten Taktsignalleitung (CKA), einer Eingangsleitung (STU) und dem ersten Steuerknoten (PQ) gekoppelt ist und dazu eingerichtet ist, die Eingangsleitung (STU) so zu steuern, dass sie unter der Steuerung des zweiten Taktsignals elektrisch mit dem ersten Steuerknoten (PQ) gekoppelt wird,
wobei die Gate-Ansteuerschaltung des Weiteren eine vierte Steuerschaltung (604) umfasst, die elektrisch mit dem ersten Knoten (Q), dem ersten Steuerknoten (PQ) und der dritten Spannungsleitung (V3) gekoppelt ist und dazu eingerichtet ist, den ersten Steuerknoten (PQ) so zu steuern, dass er unter der Steuerung des Potentials an dem ersten Knoten (Q) elektrisch mit der dritten Spannungsleitung (V3) gekoppelt wird.

5. Anzeigevorrichtung nach Anspruch 4, des Weiteren umfassend eine dritte Rücksetzschaltung (61), die elektrisch mit einer zweiten Rücksetzleitung, der dritten Spannungsleitung (V3) und dem zweiten Knoten (QB) gekoppelt ist und dazu eingerichtet ist, die dritte Spannungsleitung (V3) so zu steuern, dass sie unter der Steuerung eines zweiten Rücksetzsignals von der zweiten Rücksetzleitung elektrisch mit dem zweiten Knoten (QB) gekoppelt wird,
wobei die dritte Rücksetzschaltung (61) einen neunten Transistor (T9) und einen zehnten Transistor (T10) umfasst;
eine Gate-Elektrode des neunten Transistors (T9) elektrisch mit der zweiten Rücksetzleitung verbunden ist, eine erste Elektrode des neunten Transistors (T9) elektrisch mit der dritten Spannungsleitung (V3) verbunden ist und eine zweite Elektrode des neunten Transistors (T9) elektrisch mit einer ersten Elektrode des zehnten Transistors (T10) verbunden ist; und
eine Gate-Elektrode des zehnten Transistors (T10) elektrisch mit der zweiten Rücksetzleitung gekoppelt ist und eine zweite Elektrode des zehnten Transistors (T10) elektrisch mit dem zweiten Knoten (QB) gekoppelt ist.

6. Anzeigevorrichtung nach Anspruch 3, des Weiteren umfassend eine zweite Trennschaltung (62), die elektrisch mit der zweiten Taktsignalleitung (CKA), dem dritten Knoten (N3) und dem zweiten Knoten (QB) gekoppelt ist und dazu eingerichtet ist, den dritten Knoten (N3) so zu steuern, dass er unter der Steuerung eines zweiten Taktsignals von der zweiten Taktsignalleitung (CKA) elektrisch mit dem zweiten Knoten (QB) gekoppelt wird.

7. Anzeigevorrichtung nach Anspruch 4, wobei die dritte Steuerschaltung (603) einen elften Transistor (T11) umfasst, die zweite Steuerschaltung (602) einen zwölften Transistor (T12) und einen dreizehnten Transistor (T13) umfasst und die vierte Steuerschaltung (604) einen vierzehnten Transistor (T14) umfasst;
eine Gate-Elektrode des elften Transistors (T11) elektrisch mit der zweiten Taktsignalleitung (CKA) gekoppelt ist, eine erste Elektrode des elften Transistors (T11) elektrisch mit der Eingangsleitung (STU) gekoppelt ist und eine zweite Elektrode des elften Transistors (T11) elektrisch mit dem ersten Steuerknoten (PQ) gekoppelt ist;
eine Gate-Elektrode des vierzehnten Transistors (T14) elektrisch mit dem ersten Knoten (Q) gekoppelt ist, eine erste Elektrode des vierzehnten Transistors (T14) elektrisch mit einer dritten Spannungsleitung (V3) gekoppelt ist und eine zweite Elektrode des vierzehnten Transistors (T14) elektrisch mit dem ersten Steuerknoten (PQ) gekoppelt ist;
eine Gate-Elektrode des zwölften Transistors (T12) elektrisch mit der zweiten Taktsignalleitung (CKA) gekoppelt ist, eine erste Elektrode des zwölften Transistors (T12) elektrisch mit dem ersten Steuerknoten (PQ) gekoppelt ist, eine zweite Elektrode des zwölften Transistors (T12) elektrisch mit einer ersten Elektrode des dreizehnten Transistors (T13) gekoppelt ist, eine Gate-Elektrode des dreizehnten Transistors (T13) elektrisch mit dem zweiten Steuerknoten (PQB) gekoppelt ist und eine zweite Elektrode des dreizehnten Transistors (T13) elektrisch mit der zweiten Spannungsleitung (V2) gekoppelt ist, oder
die Gate-Elektrode des zwölften Transistors (T12) elektrisch mit dem zweiten Steuerknoten (PQB) gekoppelt ist, die erste Elektrode des zwölften Transistors (T12) elektrisch mit dem ersten Steuerknoten (PQ) gekoppelt ist, die zweite Elektrode des zwölften Transistors (T12) elektrisch mit der ersten Elektrode des dreizehnten Transistors (T13) gekoppelt ist, die Gate-Elektrode des dreizehnten Transistors (T13) elektrisch mit der zweiten Taktsignalleitung (CKA) gekoppelt ist und die zweite Elektrode des dreizehnten Transistors (T13) elektrisch mit der zweiten Spannungsleitung (V2) gekoppelt ist.

8. Anzeigevorrichtung nach Anspruch 3,
wobei die Kaskadierungs--Ausgangsschaltung (31) einen neunzehnten Transistor (T19) umfasst, eine Gate-Elektrode des neunzehnten Transistors (T19) elektrisch mit dem ersten Knoten (Q) gekoppelt ist, eine erste Elektrode des neunzehnten Transistors (T19) elektrisch mit der ersten Spannungsleitung (V1) gekoppelt ist und eine zweite Elektrode des neunzehnten Transistors (T19) elektrisch mit einem Kaskadierungs-Ausgangsende (CR) gekoppelt ist,
wobei die Kaskadierungs-Ausgangsschaltung (31) des Weiteren einen vierten Kondensator (C4) umfasst, ein erstes Ende des vierten Kondensators (C4) elektrisch mit dem ersten Knoten (Q) gekoppelt ist und ein zweites Ende des vierten Kondensators (C4) elektrisch mit dem Kaskadierungs-Ausgangsende (CR) gekoppelt ist.

9. Anzeigevorrichtung nach Anspruch 6, wobei die zweite Trennschaltung (62) einen zwanzigsten Transistor (T20) umfasst, eine Gate-Elektrode des zwanzigsten Transistors (T20) elektrisch mit der zweiten Taktsignalleitung (CKA) gekoppelt ist, eine erste Elektrode des zwanzigsten Transistors (T20) elektrisch mit dem dritten Knoten (N3) gekoppelt ist und eine zweite Elektrode des zwanzigsten Transistors (T20) elektrisch mit dem zweiten Knoten (QB) gekoppelt ist.

10. Anzeigevorrichtung nach Anspruch 1, wobei die Gate-Ansteuerschaltung des Weiteren einen einundzwanzigsten Transistor (T21) umfasst, eine Gate-Elektrode des einundzwanzigsten Transistors (T21) elektrisch mit einer ersten Hochspannungsleitung (VGH) gekoppelt ist, eine erste Elektrode des einundzwanzigsten Transistors (T21) elektrisch mit der zweiten Elektrode des sechzehnten Transistors (T16) gekoppelt ist und eine zweite Elektrode des einundzwanzigsten Transistors (T21) elektrisch mit dem ersten Knoten (Q) gekoppelt ist.

11. Ansteuerverfahren für die Anzeigevorrichtung nach einem der Ansprüche 1 bis 10, wobei ein Anzeigezeitraum eine erste Phase (S1), eine zweite Phase (S2) und eine dritte Phase (S3) umfasst, die nacheinander angeordnet sind, wobei das Ansteuerverfahren umfasst:
innerhalb der ersten Phase (S1), Steuern, durch die erste Rücksetzschaltung (12), der ersten Taktsignalleitung (CKB) so, dass sie unter der Steuerung des ersten Rücksetzsignals von der ersten Rücksetzleitung das erste Taktsignal in den ersten Steuerknoten (PQ) schreibt, und, wenn die zweite Taktsignalleitung (CKA) ein Hochspannungssignal bereitstellt, Steuern, durch die erste Trennschaltung (13), des ersten Steuerknotens (PQ) so, dass er unter der Steuerung des zweiten Taktsignals von der zweiten Taktsignalleitung (CKA) elektrisch mit dem ersten Knoten (Q) gekoppelt wird;
innerhalb der zweiten Phase (S2), wenn die zweite Taktsignalleitung (CKA) ein Hochspannungssignal bereitstellt, Steuern, durch die erste Trennschaltung (13), des ersten Steuerknotens (PQ) so, dass er unter der Steuerung des zweiten Taktsignals elektrisch mit dem ersten Knoten (Q) gekoppelt wird, und Steuern, durch die Ansteuer-Ausgangsschaltung (11), des Ansteuersignal-Ausgangsendes (O1) so, dass es unter der Steuerung des Potentials an dem ersten Knoten (Q) elektrisch mit der ersten Spannungsleitung (V1) gekoppelt wird; und
innerhalb der dritten Phase (S3), wenn die zweite Taktsignalleitung (CKA) ein Hochspannungssignal bereitstellt, Steuern, durch die erste Trennschaltung (13), des ersten Steuerknotens (PQ) so, dass er unter der Steuerung des zweiten Taktsignals elektrisch mit dem ersten Knoten (Q) gekoppelt wird.

12. Anzeigevorrichtung nach den Ansprüchen 1 bis 10, umfassend ein Anzeigesubstrat, wobei das Anzeigesubstrat des Weiteren mehrere in Spalten angeordnete Gleichstromsignalleitungen, eine Anzeigeregion und eine Randregion umfasst, wobei die Gleichstromsignalleitungen und die Gate-Ansteuerschaltung in der Randregion angeordnet sind, die Gleichstromsignalleitungen in mindestens einer Spalte auf einer von der Anzeigeregion entfernt liegenden Seite der Gate-Ansteuerschaltung angeordnet sind,und die Gleichstromsignalleitungen, die nicht die Gleichstromsignalleitungen in der mindestens einen Spalte sind, auf einer der Anzeigeregion nahe liegenden Seite der Gate-Ansteuerschaltung angeordnet sind.

## Revendications

1. Dispositif d'affichage, comprenant un circuit d'attaque de grille, dans lequel le circuit d'attaque de grille comprend un circuit de sortie d'attaque (11), un premier circuit de réinitialisation (12) et un premier circuit d'isolation (13), dans lequel
le circuit de sortie d'attaque (11) est couplé électriquement à un premier nœud (Q) et à une extrémité de sortie de signal d'attaque (O1), couplé électriquement à une première ligne de tension (V1) ou à une première ligne de signal d'horloge (CKB), et configuré pour commander l'extrémité de sortie de signal d'attaque (O1) de telle sorte qu'elle est couplée électriquement à la première ligne de tension (V1) ou à la première ligne de signal d'horloge (CKB) sous la commande d'un potentiel au premier nœud (Q) ; le circuit de sortie d'attaque (11) comprend un quinzième transistor (T15) et un deuxième condensateur (C2) ; une électrode de grille du quinzième transistor (T15) est couplée électriquement au premier nœud (Q), une première électrode du quinzième transistor (T15) est couplée électriquement à la première ligne de tension (V1) ou à la première ligne de signal d'horloge (CKB), et une seconde électrode du quinzième transistor (T15) est couplée électriquement à l'extrémité de sortie de signal d'attaque (O1) ; une première extrémité du deuxième condensateur (C2) est couplée électriquement au premier nœud (Q), et une seconde extrémité du deuxième condensateur (C2) est couplée électriquement à l'extrémité de sortie de signal d'attaque (O1) ;
dans lequel
le premier circuit de réinitialisation (12) est couplé électriquement à une première ligne de réinitialisation, à la première ligne de signal d'horloge (CKB), et à un premier nœud de commande (PQ), et configuré pour commander la première ligne de signal d'horloge (CKB) de telle sorte qu'elle écrit un premier signal d'horloge dans le premier nœud de commande (PQ) sous la commande d'un premier signal de réinitialisation provenant de la première ligne de réinitialisation ; le premier circuit de réinitialisation (12) comprend un premier transistor (T1), une électrode de grille du premier transistor (T1) est couplée électriquement à la première ligne de réinitialisation, une première électrode du premier transistor (T1) est couplée électriquement à la première ligne de signal d'horloge (CKB), et une seconde électrode du premier transistor (T1) est couplée électriquement au premier nœud de commande (PQ),
le premier circuit d'isolation (13) est couplé électriquement à une seconde ligne de signal d'horloge (CKA), au premier nœud de commande (PQ), et au premier nœud (Q), et configuré pour commander le premier nœud de commande (PQ) de telle sorte qu'il est couplé électriquement au premier nœud (Q) sous la commande d'un second signal d'horloge provenant de la seconde ligne de signal d'horloge (CKA) ; le premier circuit d'isolation (13) comprend un seizième transistor (T16) ; une électrode de commande du seizième transistor (T16) est couplée électriquement à la seconde ligne de signal d'horloge (CKA), une première électrode du seizième transistor (T16) est couplée électriquement au premier nœud de commande (PQ), et une seconde électrode du seizième transistor (T16) est couplée électriquement au premier nœud (Q) ;
dans lequel le circuit d'attaque de grille comprend en outre un circuit de commande (21) du second nœud de commande couplé à la première ligne de signal d'horloge (CKB), à la première ligne de tension (V1), à un second nœud de commande (PQB), à un troisième nœud (N3), et à la seconde ligne de signal d'horloge (CKA), et configuré pour commander le second nœud de commande (PQB) de telle sorte qu'il est couplé électriquement à la première ligne de tension (V1) sous la commande du premier signal d'horloge, et commander le troisième nœud (N3) de telle sorte qu'il est couplé électriquement à la seconde ligne de signal d'horloge (CKA) sous la commande d'un potentiel au second nœud de commande (PQB),
dans lequel le circuit de commande (21) du second nœud de commande est en outre configuré pour commander le potentiel au second nœud de commande (PQB) en fonction d'un potentiel au troisième nœud (N3) ;
dans lequel le circuit de commande (21) du second nœud de commande est en outre couplé électriquement à la ligne d'entrée (STU) et configuré pour écrire le premier signal d'horloge dans le second nœud de commande (PQB) sous la commande d'un signal d'entrée provenant de la ligne d'entrée (STU),
dans lequel le circuit de commande (21) du second nœud de commande comprend un septième transistor (T7) et un huitième transistor (T8) ; une électrode de grille du septième transistor (T7) est couplée électriquement à la ligne d'entrée (STU), une première électrode du septième transistor (T7) est couplée électriquement à la première ligne de signal d'horloge (CKB), et une seconde électrode du septième transistor (T7) est couplée électriquement à une première électrode du huitième transistor (T8) ; et une électrode de grille du huitième transistor (T8) est couplée électriquement à la ligne d'entrée (STU), et une seconde électrode du huitième transistor (T8) est couplée électriquement au second nœud de commande (PQB) ; et
dans lequel le circuit de commande (21) du second nœud de commande comprend en outre un dix-septième transistor (T17), un troisième condensateur (C3), et un dix-huitième transistor (T18) ; une électrode de grille du dix-septième transistor (T17) est couplée électriquement à la première ligne de signal d'horloge (CKB), une première électrode du dix-septième transistor (T17) est couplée électriquement à la première ligne de tension (V1), et une seconde électrode du dix-septième transistor (T17) est couplée électriquement au second nœud de commande (PQB) ; une première extrémité du troisième condensateur (C3) est couplée électriquement au second nœud de commande (PQB), et une seconde extrémité du troisième condensateur (C3) est couplée électriquement au troisième nœud (N3) ; et une électrode de grille du dix-huitième transistor (T18) est couplée électriquement au second nœud de commande (PQB), une première électrode du dix-huitième transistor (T18) est couplée électriquement à la seconde ligne de signal d'horloge (CKA), et une seconde électrode du dix-huitième transistor (T18) est couplée électriquement au troisième nœud (N3).

2. Dispositif d'affichage selon la revendication 1,
dans lequel le premier transistor (T1) est un transistor à couches minces d'oxyde, une première période de temps à haute tension ne chevauche pas une seconde période de temps à haute tension, la première période de temps à haute tension est une période de temps sur laquelle un potentiel du premier signal d'horloge est une tension élevée, et la seconde période de temps à haute tension est une période de temps sur laquelle un potentiel du second signal d'horloge est une tension élevée.

3. Dispositif d'affichage selon la revendication 1 ou 2,
dans lequel le circuit d'attaque de grille comprend en outre un circuit de sortie en cascade (31) et un circuit de réinitialisation en cascade (32), dans lequel le circuit de sortie en cascade (31) est couplé électriquement au premier nœud (Q), à une extrémité de sortie de report (CR) et à la première ligne de tension (V1), et configuré pour commander l'extrémité de sortie de report (CR) de telle sorte qu'elle est couplée électriquement à la première ligne de tension (V1) sous la commande du potentiel au premier nœud (Q), et le circuit de réinitialisation en cascade (32) est couplé électriquement à un deuxième nœud (QB), à l'extrémité de sortie de report (CR) et à une deuxième ligne de tension (V2), et configuré pour commander l'extrémité de sortie de report (CR) de telle sorte qu'elle est couplée électriquement à la deuxième ligne de tension (V2) sous la commande d'un potentiel au deuxième nœud (QB),
dans lequel le circuit de réinitialisation en cascade (32) comprend un deuxième transistor (T2) et un troisième transistor (T3) ;
une électrode de grille du deuxième transistor (T2) est couplée électriquement au deuxième nœud (QB), une première électrode du deuxième transistor (T2) est couplée électriquement à l'extrémité de sortie de report (CR), et une seconde électrode du deuxième transistor (T2) est couplée électriquement à un quatrième nœud (N4) ; et
une électrode de grille du troisième transistor (T3) est couplée électriquement au deuxième nœud (QB), une première électrode du troisième transistor (T3) est couplée électriquement au quatrième nœud (N4), et une seconde électrode du troisième transistor (T3) est couplée électriquement à la deuxième ligne de tension (V2),
dans lequel le circuit d'attaque de grille comprend en outre un premier circuit de commande (41) couplé électriquement au premier nœud (Q), à une troisième ligne de tension (V3), et au quatrième nœud (N4), et configuré pour commander la troisième ligne de tension (V3) de telle sorte qu'elle est couplée électriquement au quatrième nœud (N4) sous la commande du potentiel au premier nœud (Q),
dans lequel le premier circuit de commande (41) comprend un quatrième transistor (T4), une électrode de grille du quatrième transistor (T4) est couplée électriquement au premier nœud (Q), une première électrode du quatrième transistor (T4) est couplée électriquement à la troisième ligne de tension (V3), et une seconde électrode du quatrième transistor (T4) est couplée électriquement au quatrième nœud (N4).

4. Dispositif d'affichage selon la revendication 1 ou 2, comprenant en outre un circuit de réinitialisation de sortie (51) et un second circuit de réinitialisation (52), dans lequel le circuit de réinitialisation de sortie (51) est couplé électriquement au deuxième nœud (QB), à l'extrémité de sortie de signal d'attaque (O1) et à une quatrième ligne de tension (V4), et configuré pour commander l'extrémité de sortie de signal d'attaque (O1) de telle sorte qu'elle est couplée électriquement à la quatrième ligne de tension (V4) sous la commande du potentiel au deuxième nœud (QB), dans lequel le second circuit de réinitialisation (52) est couplé électriquement au premier nœud (Q), à la deuxième ligne de tension (V2), et au deuxième nœud (QB), et configuré pour commander la deuxième ligne de tension (V2) de telle sorte qu'elle est couplée électriquement au deuxième nœud (QB) sous la commande du potentiel au premier nœud (Q),
dans lequel un transistor dans le circuit de réinitialisation de sortie (51) est un transistor à oxyde, et une valeur de tension d'un second signal de tension provenant de la deuxième ligne de tension (V2) est inférieure à une valeur de tension d'un premier signal de tension provenant de la première ligne de tension (V1),
dans lequel le circuit de réinitialisation de sortie (51) comprend un cinquième transistor (T5) et un premier condensateur (C1), et le second circuit de réinitialisation (52) comprend un sixième transistor (T6) ;
une électrode de grille du cinquième transistor (T5) est couplée électriquement au deuxième nœud (QB), une première électrode du cinquième transistor (T5) est couplée électriquement à l'extrémité de sortie de signal d'attaque (O1), et une seconde électrode du cinquième transistor (T5) est couplée électriquement à la quatrième ligne de tension (V4) ;
une première extrémité du premier condensateur (C1) est couplée électriquement au deuxième nœud (QB), et une seconde extrémité du premier condensateur (C1) est couplée électriquement à la quatrième ligne de tension (V4) ; et
une électrode de grille du sixième transistor (T6) est couplée électriquement au premier nœud (Q), une première électrode du sixième transistor (T6) est couplée électriquement à la deuxième ligne de tension (V2), et une seconde électrode du sixième transistor (T6) est couplée électriquement au deuxième nœud (QB),
dans lequel le circuit d'attaque de grille comprend en outre un second circuit de commande (602) couplé électriquement au premier nœud de commande (PQ), à la seconde ligne de signal d'horloge (CKA), à la deuxième ligne de tension (V2) et au second nœud de commande (PQB), et configuré pour commander le premier nœud de commande (PQ) de telle sorte qu'il est couplé électriquement à la deuxième ligne de tension (V2) sous la commande du potentiel au second nœud de commande (PQB) et du second signal d'horloge provenant de la seconde ligne de signal d'horloge (CKA),
dans lequel le circuit d'attaque de grille comprend en outre un troisième circuit de commande (603) couplé électriquement à la seconde ligne de signal d'horloge (CKA), à une ligne d'entrée (STU), et au premier nœud de commande (PQ), et configuré pour commander la ligne d'entrée (STU) de telle sorte qu'elle couplée électriquement au premier nœud de commande (PQ) sous la commande du second signal d'horloge,
dans lequel le circuit d'attaque de grille comprend en outre un quatrième circuit de commande (604) couplé électriquement au premier nœud (Q), au premier nœud de commande (PQ), et à la troisième ligne de tension (V3), et configuré pour commander le premier nœud de commande (PQ) de telle sorte qu'il est couplé électriquement à la troisième ligne de tension (V3) sous la commande du potentiel au premier nœud (Q).

5. Dispositif d'affichage selon la revendication 4, comprenant en outre un troisième circuit de réinitialisation (61) couplé électriquement à une seconde ligne de réinitialisation, à la troisième ligne de tension (V3), et au deuxième nœud (QB), et configuré pour commander la troisième ligne de tension (V3) de telle sorte qu'elle est couplée électriquement au deuxième nœud (QB) sous la commande d'un deuxième signal de réinitialisation provenant de la seconde ligne de réinitialisation,
dans lequel le troisième circuit de réinitialisation (61) comprend un neuvième transistor (T9) et un dixième transistor (T10) ;
une électrode de grille du neuvième transistor (T9) est couplée électriquement à la seconde ligne de réinitialisation, une première électrode du neuvième transistor (T9) est couplée électriquement à la troisième ligne de tension (V3), et une seconde électrode du neuvième transistor (T9) est couplée électriquement à une première électrode du dixième transistor (T10) ; et
une électrode de grille du dixième transistor (T10) est couplée électriquement à la seconde ligne de réinitialisation et une seconde électrode du dixième transistor (T10) est couplée électriquement au deuxième nœud (QB).

6. Dispositif d'affichage selon la revendication 3, comprenant en outre un second circuit d'isolation (62) couplé électriquement à la seconde ligne de signal d'horloge (CKA), au troisième nœud (N3), et au deuxième nœud (QB), et configuré pour commander le troisième nœud (N3) de telle sorte qu'il est couplé électriquement au deuxième nœud (QB) sous la commande d'un second signal d'horloge provenant de la seconde ligne de signal d'horloge (CKA).

7. Dispositif d'affichage selon la revendication 4, dans lequel le troisième circuit de commande (603) comprend un onzième transistor (T11), le deuxième circuit de commande (602) comprend un douzième transistor (T12), et un treizième transistor (T13), et le quatrième circuit de commande (604) comprend un quatorzième transistor (T14) ;
une électrode de grille du onzième transistor (T11) est couplée électriquement à la seconde ligne de signal d'horloge (CKA), une première électrode du onzième transistor (T11) est couplée électriquement à la ligne d'entrée (STU), et une seconde électrode du onzième transistor (T11) est couplée électriquement au premier nœud de commande (PQ) ;
une électrode de grille du quatorzième transistor (T14) est couplée électriquement au premier nœud (Q), une première électrode du quatorzième transistor (T14) est couplée électriquement à une troisième ligne de tension (V3), et une seconde électrode du quatorzième transistor (T14) est couplée électriquement au premier nœud de commande (PQ) ;
une électrode de grille du douzième transistor (T12) est couplée électriquement à la seconde ligne de signal d'horloge (CKA), une première électrode du douzième transistor (T12) est couplée électriquement au premier nœud de commande (PQ), une seconde électrode du douzième transistor (T12) est couplée électriquement à une première électrode du treizième transistor (T13), une électrode de grille du treizième transistor (T13) est couplée électriquement au second nœud de commande (PQB), et une seconde électrode du treizième transistor (T13) est couplée électriquement à la deuxième ligne de tension (V2), ou
l'électrode de grille du douzième transistor (T12) est couplée électriquement au second nœud de commande (PQB), la première électrode du douzième transistor (T12) est couplée électriquement au premier nœud de commande (PQ), la seconde électrode du douzième transistor (T12) est couplée électriquement à la première électrode du treizième transistor (T13), l'électrode de grille du treizième transistor (T13) est couplée électriquement à la seconde ligne de signal d'horloge (CKA), et la seconde électrode du treizième transistor (T13) est couplée électriquement à la deuxième ligne de tension (V2).

8. Dispositif d'affichage selon la revendication 3,
dans lequel le circuit de sortie en cascade (31) comprend un dix-neuvième transistor (T19), une électrode de grille du dix-neuvième transistor (T19) est couplée électriquement au premier nœud (Q), et une première électrode du dix-neuvième transistor (T19) est couplée électriquement à la première ligne de tension (V1), et une seconde électrode du dix-neuvième transistor (T19) est couplée électriquement à une extrémité de sortie en cascade (CR),
dans lequel le circuit de sortie en cascade (31) comprend en outre un quatrième condensateur (C4), une première extrémité du quatrième condensateur (C4) est couplée électriquement au premier nœud (Q), et une seconde extrémité du quatrième condensateur (C4) est couplée électriquement à l'extrémité de sortie en cascade (CR).

9. Dispositif d'affichage selon la revendication 6, dans lequel le deuxième circuit d'isolation (62) comprend un vingtième transistor (T20), une électrode de grille du vingtième transistor (T20) est couplée électriquement à la seconde ligne de signal d'horloge (CKA), une première électrode du vingtième transistor (T20) est couplée électriquement au troisième nœud (N3), et une seconde électrode du vingtième transistor (T20) est couplée électriquement au deuxième nœud (QB).

10. Dispositif d'affichage selon la revendication 1, dans lequel le circuit d'attaque de grille comprend en outre un vingt et unième transistor (T21), une électrode de grille du vingt et unième transistor (T21) est couplée électriquement à une première ligne à haute tension (VGH), une première électrode du vingt et unième transistor (T21) est couplée électriquement à la seconde électrode du seizième transistor (T16) et une seconde électrode du vingt et unième transistor (T21) est couplée électriquement au premier nœud (Q).

11. Procédé d'attaque pour le dispositif d'affichage selon l'une quelconque des revendications 1 à 10, une période d'affichage comprenant une première phase (S1), une deuxième phase (S2), et une troisième phase (S3) situées les unes après les autres, le procédé d'attaque comprenant de :
pendant la première phase (S1), commander, par le premier circuit de réinitialisation (12), la première ligne de signal d'horloge (CKB) de telle sorte qu'elle écrit le premier signal d'horloge dans le premier nœud de commande (PQ) sous la commande du premier signal de réinitialisation provenant de la première ligne de réinitialisation, et lorsque la seconde ligne de signal d'horloge (CKA) fournit un signal à haute tension, commander, par le premier circuit d'isolation (13), le premier nœud de commande (PQ) de telle sorte qu'il est couplé électriquement au premier nœud (Q) sous la commande du second signal d'horloge provenant de la seconde ligne de signal d'horloge (CKA) ;
pendant la deuxième phase (S2), lorsque la seconde ligne de signal d'horloge (CKA) fournit un signal à haute tension, commander, par le premier circuit d'isolation (13), le premier nœud de commande (PQ) de telle sorte qu'il est couplé électriquement au premier nœud (Q) sous la commande du second signal d'horloge, et commander, par le circuit de sortie d'attaque (11), l'extrémité de sortie de signal d'attaque (O1) de telle sorte qu'elle est couplée électriquement à la première ligne de tension (V1) sous la commande du potentiel au premier nœud (Q) ; et
pendant la troisième phase (S3), lorsque la seconde ligne de signal d'horloge (CKA) fournit un signal à haute tension, commander, par le premier circuit d'isolation (13), le premier nœud de commande (PQ) de telle sorte qu'il est couplé électriquement au premier nœud (Q) sous la commande du second signal d'horloge.

12. Dispositif d'affichage selon les revendications 1 à 10, comprenant un substrat d'affichage, dans lequel le substrat d'affichage comprend en outre une pluralité de lignes de signal à courant continu disposées en colonnes, une zone d'affichage, et une zone périphérique, dans lequel les lignes de signal à courant continu et le circuit d'attaque de grille sont disposés dans zone région périphérique, les lignes de signal à courant continu dans au moins une colonne sont disposées sur un côté de le circuit d'attaque de grille éloigné de la zone d'affichage, et les lignes de signal à courant continu autres que les lignes de signal à courant continu dans la au moins une colonne sont disposées sur un côté de le circuit d'attaque de grille situé près de la zone d'affichage.
